# EUROPÄISCHE PATENTSCHRIFT

(11) **EP 1 979 934 B1**
(45) Veröffentlichungstag und Bekanntmachung des Hinweises auf die Patenterteilung: **21.04.2010**
(21) Anmeldenummer: 07702904.9
(22) Anmeldetag: 19.01.2007
(51) Int. Cl.: H01L 21/322, H01L 21/265, H01L 21/263

(54) **VERFAHREN ZUR BEHANDLUNG EINES SAUERSTOFF ENTHALTENDEN HALBLEITERWAFERS UND HALBLEITERBAUELEMENT**
METHOD FOR TREATING AN OXYGEN-CONTAINING SEMICONDUCTOR WAFER, AND SEMICONDUCTOR COMPONENT
PROCEDE DE TRAITEMENT D'UNE PLAQUETTE SEMI-CONDUCTRICE CONTENANT DE L'OXYGENE ET COMPOSANT SEMI-CONDUCTEUR

(30) Priorität: 20.01.2006 DE 102006002903; 29.03.2006 DE 102006014639; 04.09.2006 DE 102006041402
(43) Veröffentlichungstag der Anmeldung: 15.10.2008
(60) Teilanmeldung: 09150636.0
(73) Patentinhaber: Infineon Technologies Austria AG, 9500 Villach (AT)
(72) Erfinder: SCHULZE, Hans-Joachim, 85521 Ottobrunn (DE); STRACK, Helmut, 80804 München (DE); MAUDER, Anton, 83059 Kolbermoor (DE)
(74) Vertreter: Bickel, Michael
(86) Internationale Anmeldenummer: PCT/EP2007/000475
(87) Internationale Veröffentlichungsnummer: WO 2007/085387

(56) Entgegenhaltungen:
- WO-A-99/21222
- WO-A-2004/030103
- DE-A1- 4 218 685
- US-A- 5 229 305
- US-A1- 2003 003 692
- US-B1- 6 451 672
- "Oxygen gettering and precipitation at MeV Si+ ion implantation induced damage in silicon" APPLIED PHYSICS LETTERS, AIP, AMERICAN INSTITUTE OF PHYSICS, MELVILLE, NY, US, Bd. 69, Nr. 25, 16. Dezember 1996 (1996-12-16), Seiten 3899-3901, XP012016852 ISSN: 0003-6951
- GONG S S ET AL: "IMPLANTATION GETTERING IN SILICON" SOLID STATE ELECTRONICS, ELSEVIER SCIENCE PUBLISHERS, BARKING, GB, Bd. 30, Nr. 2, Februar 1987 (1987-02), Seiten 209-211, XP000836042 ISSN: 0038-1101
- BAGINSKI T A: "BACK-SIDE GERMANIUM ION IMPLANTATION GETTERING OF SILICON" JOURNAL OF THE ELECTROCHEMICAL SOCIETY, ELECTROCHEMICAL SOCIETY. MANCHESTER, NEW HAMPSHIRE, US, Bd. 135, Nr. 7, 1. Juli 1988 (1988-07-01), Seiten 1842-1843, XP000021019 ISSN: 0013-4651
- SILBER D ET AL: "IMPROVED DYNAMIC PROPERTIES OF GTO-THYRISTORS AND DIODES BY PROTON IMPLANTATION" INTERNATIONAL ELECTRON DEVICES MEETING. WASHINGTON, DEC. 1 - 4, 1985, WASHINGTON, IEEE, US, 1. Dezember 1985 (1985-12-01), Seiten 162-165, XP000195830

## Beschreibung

### TECHNISCHER HINTERGRUND

Die vorliegende Erfindung betrifft ein Verfahren zur Behandlung eines Sauerstoff enthaltenden Halbleiterwafers.

Bekannte Verfahren zur Herstellung von Halbleiter-Einkristallen, z.B. Silizium-Einkristallen, die für die Realisierung von Halbleiterbauelementen benötigt werden, sind das sogenannte Float-Zone-Verfahren (FZ-Verfahren) oder das Czochralski-Verfahren (CZ-Verfahren). Aus den durch diese Verfahren hergestellten einkristallinen Halbleiterstäben werden scheibenartige Halbleiterwafer abgeschnitten, die die Grundlage für die Herstellung von Halbleiterbauelementen bilden. Das CZ-Verfahren ist im Vergleich zum FZ-Verfahren kostengünstiger durchführbar, bietet aber den Nachteil, dass der Einkristall bedingt durch das Herstellungsverfahren eine hohe Sauerstoffkonzentration aufweist, die typischerweise im Bereich von einigen 10¹⁷ Atomen/cm³ liegt.

Temperaturprozesse, die während der Verfahren zur Herstellung und Prozessierung der Halbleiterwafern auftreten, führen dazu, dass der in dem Wafer in hoher Konzentration vorhandene Sauerstoff sogenannte Sauerstoffausscheidungen bzw. Sauerstoffpräzipitate bildet. Hierunter sind Sauerstoffagglomerate oder Sauerstoff-Leerstellen-Agglomerate in dem Halbleiterkristall zu verstehen. Diese Ausscheidungen wirken unter anderem als Getterzentren für Schwermetallatome, die während des Herstellverfahrens der Bauelemente in den Wafer gelangen können. Sofern solche Ausscheidungen in einer aktiven Bauelementzone eines Halbleiterbauelements vorhanden sind, führen sie allerdings zu einer Verschlechterung der Bauelementeigenschaften, indem sie als Rekombinationszentren für freie Ladungsträger wirken und indem sie als Generationszentren für Ladungsträgerpaare wirken, wobei Letzteres zu einer Erhöhung des im Sperrbetrieb des Bauelements fließenden Leckstroms führt.

Aus den zuvor genannten Gründen sind CZ-Wafer ohne weitere Behandlung für die Realisierung von Leistungsbauelementen, die eine Spannungsfestigkeit von einigen hundert Volt besitzen, nur bedingt geeignet. CZ-Wafer eignen sich ohne weitere Behandlung für diese Bauelemente lediglich als Halbleitersubstrat, auf welches mittels aufwendiger und damit kostenintensiver Epitaxieverfahren weitere (sauerstoffarme) Halbleiterschichten aufgebracht werden, in welchen die eine Sperrspannung aufnehmenden Bereiche eines Leistungsbauelements, beispielsweise die Driftzone eines MOSFET oder die n-Basis eines IGBT, realisiert werden.

Es gibt verschiedene Verfahren, Sauerstoffausscheidungen in oberflächennahen Bereichen eines CZ-Wafers zu verhindern, so dass diese Bereiche für die Herstellung von aktiven Bauelementzonen genutzt werden können. Gleichzeitig werden in tiefer gelegenen Bereichen bewusst Sauerstoffausscheidungen erzeugt, die dort als "intrinsische Getterzentren" für in den Wafer eingebrachte, insbesondere unerwünschte Verunreinigungen wie z. B. Schwermetallatome dienen.

Ein bekanntes Verfahren, Sauerstoffausscheidungen in oberflächennahen Bereichen eines Wafers zu verhindern, besteht darin, die Sauerstoffkonzentration in diesem Bereich des Wafers zu reduzieren, indem Sauerstoffatome aus dem oberflächennahen Bereich des Wafers mittels eines Temperaturprozesses ausdiffundiert werden.

Die US 6,849,119 B2 (Falster) beschreibt ein Verfahren, bei dem ein CZ-Halbleiterwafer einem Temperaturprozess unterzogen wird, bei dem die Rückseite des Wafers einer nitridierende Atmosphäre und dessen Vorderseite einer nicht-nitridierenden Atmosphäre ausgesetzt wird. Diese Temperaturbehandlung führt zur Erzeugung von Kristallleerstellen, wobei das Maximum eines sich einstellenden Leerstellenprofils näher an der Rückseite als an der Vorderseite liegt. Der Wafer wird anschließend einer weiteren Temperaturbehandlung bei Temperaturen von 800°C und 1000°C unterzogen, wodurch Sauerstoffausscheidungen in Bereichen mit hoher Leerstellenkonzentration entstehen.

Weitere Verfahren zur Behandlung eines Wafers mit dem Ziel eine präzipitatarme Halbleiterzone in einem an eine Oberfläche angrenzenden Bereich eines Wafers zu erzeugen, sind in der US 5,882,989 (Falster) oder US 5,994,761 (Falster) beschrieben.

Die EP 0769809 A1 (Schulze) beschreibt ein Verfahren zur Reduzierung der Leerstellenkonzentration in einem Wafer, indem interstitielles Silizium infolge eines Oxidationsprozesses in den Wafer injiziert wird.

In Wondrak, W.: "Einsatz von Protonenbestrahlung in der Technologie der Leistungshalbleiter", in: Archiv für Elektrotechnik, 1989, Band 72, Seite 133 - 140, ist ein Verfahren zur n-Dotierung eines Halbleitermaterials durch Protonenbestrahlung und anschließende Durchführung eines Temperaturschrittes beschrieben.

### ZUSAMMENFASSUNG

Aufgabe der vorliegenden Erfindung ist es, ein Verfahren zur Behandlung eines Sauerstoff enthaltenden, für die Herstellung von Halbleiterbauelementen dienenden Wafers zur Verfügung zu stellen, durch welches Sauerstoffausscheidungen in einem oberflächennahen Bereich des Wafers verhindert werden und bei dem bevorzugt in einem dem oberflächennahen Bereich gegenüberliegenden Scheibenbereich eine Zone erzeugt wird, die eine hohe Dichte von Sauerstoffausscheidungen aufweist.

Diese Aufgabe wird durch ein Verfahren nach Anspruch 1 und 55 gelöst. Die Erfindung betrifft außerdem ein vertikales Halbleiterbauelement nach Anspruch 50. Vorteilhafte Ausgestaltungen sind Gegenstand der Unteransprüche.

Ein Ausführungsbeispiel des erfindungsgemäßen Verfahrens zur Behandlung eines Sauerstoff enthaltenden Halbleiterwafers, der eine erste Seite, eine der ersten Seite gegenüberliegende zweite Seite, einen sich an die erste Seite anschließenden ersten Halbleiterbereich und einen sich an die zweite Seite anschließenden zweiten Halbleiterbereich aufweist, sieht vor, die zweite Seite des Wafers mit hochenergetischen Teilchen zu bestrahlen, um dadurch Kristalldefekte - wie z. B. Leerstellen, Doppelleerstellen oder Leerstellen/Sauerstoff-Komplexe - in dem zweiten Halbleiterbereich des Wafers zu erzeugen. Anschließend wird ein erster Temperaturprozess durchgeführt, bei dem der Wafer für eine vorgegebene Zeitdauer auf Temperaturen zwischen 700° C und 1100° C aufgeheizt wird.

Während dieses ersten Temperaturprozesses bilden sich in dem zweiten Halbleiterbereich, der im Vergleich zu dem ersten Halbleiterbereich eine hohe Konzentration an Kristalldefekten und damit eine hohe Konzentration an Kristallgitterleerstellen aufweist, z. B. höherwertige Leerstellen (V) -Sauerstoff (O)-Komplexe (z. B. O₂V-Komplexe). Diese Leerstellen-Sauerstoff-Komplexe wirken als Nukleationskeime, an die sich weitere Sauerstoffatome bzw. Sauerstoffionen oder auch weitere Leerstellen/Sauerstoff-Komplexe anlagern, wodurch stabile Sauerstoffagglomerate in dem zweiten Halbleiterbereich entstehen. Die Leerstellen-Sauerstoff-Komplexe bzw. die Sauerstoffagglomerate wirken darüber hinaus als Getterzentren für in dem Halbleiterwafer vorhandene Verunreinigungen, wie beispielsweise Schwermetallatome, und für Gitterleerstellen. Diese Getterwirkung der in dem zweiten Halbleiterbereich vorhandenen Leerstellen-Sauerstoff-Komplexe und Sauerstoffagglomerate führt darüber hinaus zu einer Diffusion von Gitterleerstellen aus dem ersten Halbleiterbereich in den zweiten Halbleiterbereich, wodurch der erste Halbleiterbereich an Gitterleerstellen verarmt. Bedingt durch das Fehlen von Gitterleerstellen in dem ersten Halbleiterbereich können sich in diesem Halbleiterbereich keine oder nur sehr wenige Sauerstoffausscheidungen (Sauerstoffpräzipitate) bilden, wodurch in dem sich an die erste Seite anschließenden ersten Halbleiterbereich eine an Sauerstoffpräzipitaten arme Halbleiterzone, eine sogenannten "Denuded Zone" entsteht. Eine solche Halbleiterzone wird nachfolgend als präzipitatarme Zone bezeichnet.

Mittels des erläuterten Verfahrens kann eine deutlich größere vertikale Ausdehnung der von Sauerstoffausscheidungen weitgehend freien Zone als bei bekannten Verfahren erreicht werden. Dies ist insbesondere geeignet für vertikale Leistungshalbleiterbauelemente, die Durchbruchspannungen oberhalb von 500 V aufweisen sollen und bei denen somit entsprechend große vertikale Abmessungen einer die Sperrspannung aufnehmenden Bauelementzone, z.B. der Driftzone bei einem MOSFET, erforderlich sind.

Das erläuterte Verfahren zur Herstellung der präzipitatarmen Zone führt darüber hinaus im Vergleich zu herkömmlichen Verfahren zu einer homogeneren präzipitatarmen Zone. Ein Implantationsprozess führt aufgrund der sehr geringen Schwankungen der Implantationsdosis in lateraler Richtung, d.h. quer zur Implantationsrichtung, zu einer deutlich homogeneren Verteilung der Leerstellenkonzentration in der lateralen Richtung als beispielsweise ein herkömmlicher RTA-Prozess (RTA = Rapid Thermal Annealing) in einer nitridierenden Atmosphäre. Ein Implantationsprozess ist außerdem unempfindlich gegen dünne, auf der Waferoberfläche vorhandene "parasitäre" Schichten, während solche Schichten bei einem RTA-Prozess, der an der Waferoberfläche angreift, die Geschwindigkeiten von Oberflächenreaktionen, und damit die Leerstellenerzeugung, deutlich beeinflussen.

Die Bestrahlung des Halbleiterkörpers mit hochenergetischen Teilchen zur Erzeugung von Kristalldefekten, insbesondere zur Erzeugung von Gitterleerstellen, führt zu einer hohen Konzentration von Gitterleerstellen in dem zweiten Halbleiterbereich, damit zu einer hohen Konzentration an Sauerstoffpräzipitaten in dem zweiten Halbleiterbereich, da die Leerstellen die Sauerstoffpräzipitation, d.h. die Bildung solcher Präzipitate, erheblich begünstigen. Außerdem führt die hohe Leerstellenkonzentration in dem zweiten Halbleiterbereich zu einer besonders wirksamen Ausdiffusion von Gitterleerstellen aus dem ersten Halbleiterbereich in den zweiten Halbleiterbereich. Die Gitterleerstellen können durch die Bestrahlung mit hochenergetischen Teilchen mit einer hohen Reproduzierbarkeit innerhalb eines Wafers und von Wafer zu Wafer hergestellt werden, was einen weiteren Vorteil gegenüber bekannten Verfahren darstellt.

Während bei einem Temperaturprozess in einer nitridierenden Atmosphäre lediglich eine Leerstellenkonzentration zwischen 10¹² und 10¹³ Leerstellen pro Kubikzentimeter (cm³) erreicht werden kann, lassen sich bei einer Bestrahlung des Halbleiterkörpers beispielsweise mit Protonen Leerstellenkonzentrationen von mehr als 10¹⁸ Leerstellen pro cm³ erzeugen, was zu einer erheblichen Verstärkung des gewünschten Effekts führt. Ein weiterer Vorteil der vorliegenden Erfindung besteht darin, dass sich durch entsprechende Wahl der Bestrahlungsenergie und Bestrahlungsdosis im Gegensatz zu einer Methode, die Nitridierungsschritte zur Leerstellenerzeugung verwendet, nahezu beliebige Leerstellenverteilungen in der Halbleiterscheibe einstellen lassen; insbesondere können auch in relativ großer Tiefe des Halbleiterkristalls sehr hohe Leerstellenkonzentrationen erzeugt werden.

Die zur Bestrahlung verwendeten hochenergetischen Teilchen sind insbesondere nicht-dotierende Teilchen, wie Protonen, Edelgasionen, z. B. Heliumionen, Neonionen oder Argonionen, oder Halbleiterionen, z. B. Germaniumionen oder Siliziumionen. Als hochenergetische Teilchen zur Bestrahlung des Halbleiterkörpers mit dem Ziel, Kristalldefekte zu erzeugen, eignen sich jedoch auch,dotierende Teilchen, wie beispielsweise Phosphorionen. Da die Eindringtiefe der hochenergetischen Teilchen bei einer gegebenen Bestrahlungsenergie aber nicht zu gering sein sollte, kommen vorzugsweise Protonen oder Heliumionen zur Anwendung, die bei einer gegebenen Energie tiefer eindringen als die schwereren Teilchen.

### KURZE BESCHREIBUNG DER FIGUREN

Ausführungsbeispiele der vorliegenden Erfindung werden nachfolgend anhand von Figuren näher erläutert.
- Figur 1: veranschaulicht ein erfindungsgemäßes Verfahren zur Behandlung eines Halbleiterwafers während unterschiedlicher Verfahrensschritte.
- Figur 2: veranschaulicht eine Abwandlung des anhand von Figur 1 erläuterten erfindungsgemäßen Verfahrens.
- Figur 3: veranschaulicht ein Verfahren zur Herstellung einer n-dotierten Halbleiterzone in einer präzipitatarmen Halbleiterzone eines CZ-Halbleiterwafers.
- Figur 4: zeigt den Halbleiterwafer nach Durchführung weiterer Verfahrensschritte, bei denen eine Epitaxieschicht auf eine erste Seite des Halbleiterwafers aufgebracht wird.
- Figur 5: zeigt in Seitenansicht im Querschnitt einen Leistungs-MOSFET oder Leistungs-IGBT, der in einem nach dem erfindungsgemäßen Verfahren behandelten Halbleiterwafer realisiert ist.
- Figur 6: zeigt in Seitenansicht im Querschnitte eine Leistungsdiode, die in einem nach dem erfindungsgemäßen Verfahren behandelten Halbleiterwafer realisiert ist.

### DETAILLIERTE BESCHREIBUNG DER FIGUREN

In den Figuren bezeichnen, sofern nicht anders angegeben, gleiche Bezugszeichen gleiche Waferbereich bzw. Bauelementbereiche mit gleicher Bedeutung.

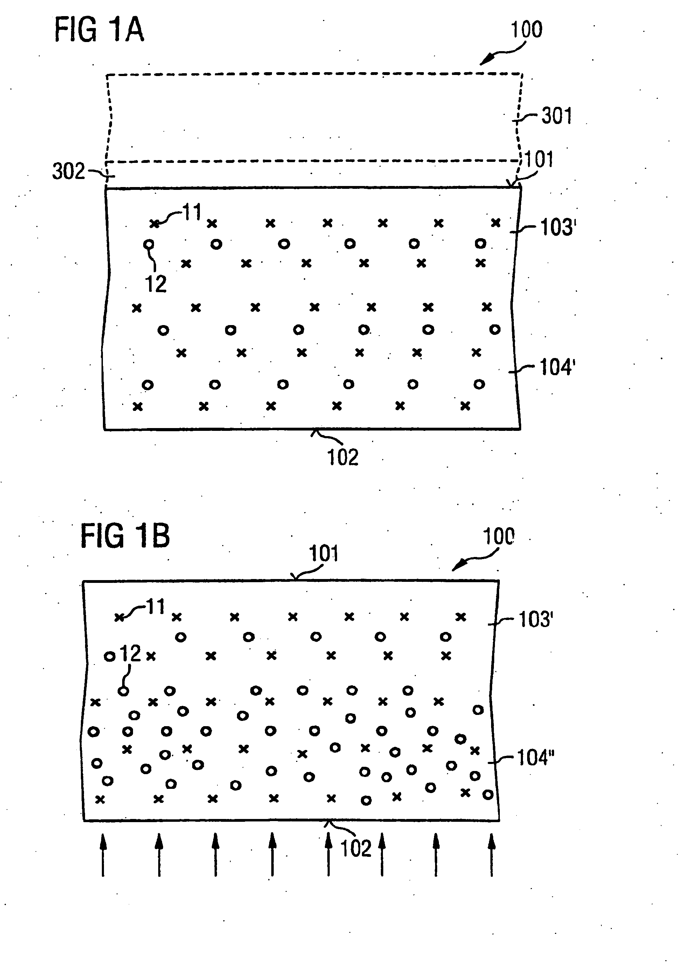

Figur 1A zeigt in Seitenansicht im Querschnitt schematisch einen Ausschnitt eines Sauerstoff enthaltenden Halbleiterwafers 100. Dieser Wafer ist von einem durch ein Tiegelziehverfahren bzw. Czochralski-Verfahren hergestellten Einkristall abgeschnitten und wird nachfolgend als CZ-Wafer bezeichnet. Die Sauerstoffkonzentration eines solchen CZ-Wafers liegt üblicherweise oberhalb von 5·10¹⁷ Atomen/cm³. Der Wafer kann undotiert sein oder kann eine Grunddotierung, insbesondere eine homogene Grunddotierung, beispielsweise eine n-Grunddotierung besitzen, die bereits bei Ziehen des Einkristalls während des Czochralski-Verfahrens erzeugt wird. Insbesondere kann der Wafer zu Beginn des Verfahrens ausschließlich diese Grunddotierung aufweisen, wurde zuvor also keinen Implantations- oder Diffusionsprozessen - die immer mit Temperaturprozessen verbunden sind - zur Herstellung weiterer dotierter Bereiche unterzogen und wurde auch keinem Implantationsprozess unterzogen, durch den zunächst nur Dotierstoffatome implantiert wurden, ohne diese durch einen Temperaturprozess zu aktivieren.

Der Wafer 100 weist eine erste Seite 101, die nachfolgend als Vorderseite bezeichnet wird, und eine zweite Seite 102, die nachfolgend als Rückseite bezeichnet wird, auf. In dem Kristallgitter des Wafers vorhandene Sauerstoffatome sind in Figur 1A schematisch durch Kreuze dargestellt und mit dem Bezugszeichen 11 bezeichnet. Neben Sauerstoffatomen sind in dem Kristallgitter nach Abschluss des Czochralski-Verfahrens unweigerlich auch Leerstellen und Leerstellenagglomerate vorhanden, die in Figur 1A schematisch als Kreise dargestellt und mit dem Bezugszeichen 12 bezeichnet sind. Ein sich an die Vorderseite 101 in vertikaler Richtung des Wafers anschließender Halbleiterbereich wird nachfolgend als erster Halbleiterbereich 103' bezeichnet, während ein sich an die Rückseite 102 in vertikaler Richtung des Wafers 100 anschließender Bereich nachfolgend als zweiter Halbleiterbereich 104' bezeichnet wird.

Ziel ist es, in dem sich an die Vorderseite 101 anschließenden ersten Halbleiterbereich 103' eine an Sauerstoffausscheidungen arme Halbleiterzone bzw. präzipitatarme Halbleiterzone (Denuded Zone) zu erzeugen.

Ein Ausführungsbeispiel des erfindungsgemäßen Verfahrens sieht Bezug nehmend auf Figur 1B hierzu vor, den Wafer 100 über dessen Rückseite 102 mit hochenergetischen Teilchen zu bestrahlen, um dadurch in dem zweiten Halbleiterbereich 104 Kristalldefekte, insbesondere Gitterleerstellen, zu erzeugen, so dass in dem zweiten Halbleiterbereich 104' im Vergleich zu dem ersten Halbleiterbereich 103 eine erhöhte Leerstellenkonzentration vorhanden ist. Diese eine erhöhte Leerstellenkonzentration aufweisende Halbleiterzone ist in Figur 1B mit dem Bezugszeichen 104" bezeichnet. Unter den durch die Bestrahlung mit hochenergetischen Teilchen hergestellten Leerstellen sind nachfolgend insbesondere Einfach-Leerstellen (V), Doppelleerstellen (VV) und auch Leerstellen-Sauerstoff-Komplexe (OV) zu verstehen. Es können jedoch auch höherwertige Leerstellen-Sauerstoff-Komplexe oder andere Kristalldefekte auftreten.

Als Teilchen für die Bestrahlung des Wafers 100 eignen sich insbesondere nicht-dotierende Teilchen, wie Protonen, Edelgasionen oder Halbleiterionen.

Nach Erzeugung der Leerstellen in dem zweiten Halbleiterbereich 104 durch die Bestrahlung mit hochenergetischen Teilchen erfolgt ein erster Temperaturprozess, bei dem der Wafer für eine bestimmte Zeitdauer auf Temperaturen zwischen 70.0° C und 1100° C aufgeheizt wird. Die Temperatur und Dauer dieses Temperaturprozesses sind dabei so gewählt, dass in dem eine hohe Leerstellenkonzentration aufweisenden zweiten Halbleiterbereich 104" Leerstellen-Sauerstoff-Zentren (O₂V-Zentren) oder auch höherwertige Leerstellen-Sauerstoff-Komplexe entstehen. Der Temperaturprozess kann insbesondere derart gestaltet sein, dass zeitlich aufeinanderfolgend wenigstens zwei verschiedene Temperaturen eingestellt werden, die jeweils für eine vorgegebene Zeitdauer gehalten werden. Die Zeitdauern dieser einzelnen "Temperaturplateaus" können dabei gleich lang oder auch unterschiedlich lang sein.

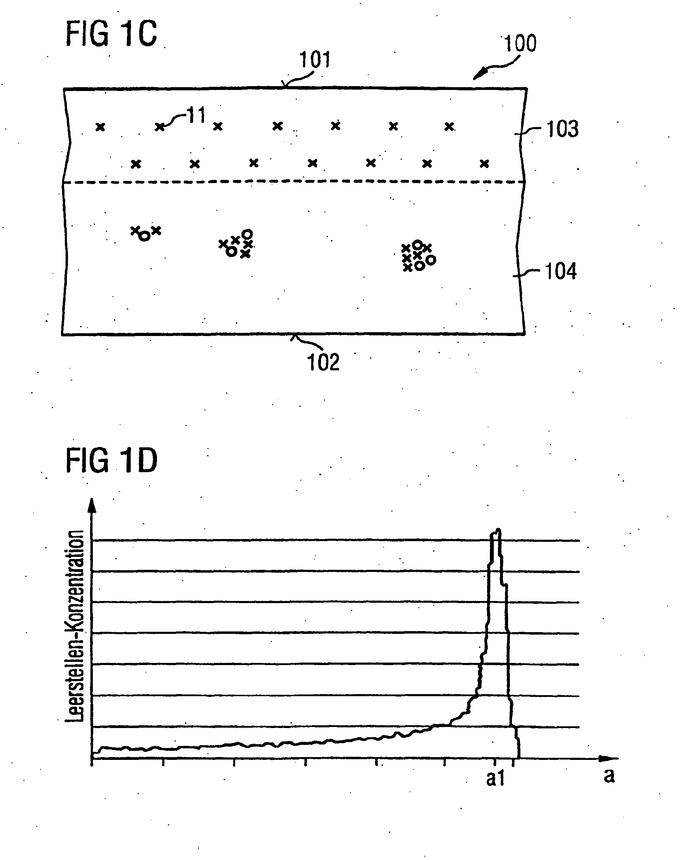

Die durch die Bestrahlung und den Temperaturprozess erzeugten Leerstellen-Sauerstoff-Zentren wirken als Nukleationskeime für Sauerstoffausscheidungen, so dass sich während des ersten Temperaturprozesses stabile Sauerstoffagglomerate in dem zweiten Halbleiterbereich 104 bilden. Die Nukleationskeime und Sauerstoffagglomerate wirken außerdem als Getterzentren für in dem Halbleiterwafer vorhandene, bzw. während nachfolgender Hochtemperaturprozesse in den Halbleiter eindiffundierende, Verunreinigungen, wie beispielsweise Schwermetallatome, und wirken zudem als Getterzentren für Gitterleerstellen. Dies führt dazu, dass während des ersten Temperaturprozesses Gitterleerstellen aus dem ersten Halbleiterbereich 103 in den zweiten Halbleiterbereich 104 eindiffundieren, wodurch in dem ersten Halbleiterbereich 103 eine leerstellenarme Halbleiterzone entsteht. Die Verarmung des ersten Halbleiterbereichs 103 an Leerstellen wirkt einer Entstehung von Sauerstoffpräzipitaten in dem ersten Halbleiterbereich 103 entgegen, so dass nach Abschluss des Temperaturprozesses der erste Halbleiterbereich 103' eine präzipitatarme Halbleiterzone bildet, die in Figur 1C mit dem Bezugszeichen 103 bezeichnet ist.

Die in dem zweiten Halbleiterbereich 104 vorhandenen Nukleationskeime und Sauerstoffagglomerate sind stabil und werden durch nachfolgende Temperaturprozesse, wie sie beispielsweise bei der Herstellung von Halbleiterbauelementen auf Basis des Wafer angewendet werden, nicht mehr aufgelöst. Mangels vorhandener Leerstellen in dem ersten Halbleiterbereich 103 können sich während solcher Temperaturprozesse in dem ersten Halbleiterbereich 103 keine Sauerstoffpräzipitate bilden, welche die Funktion eines Halbleiterbauelements, insbesondere eines Leistungsbauelements negativ beeinflussen würden, da ohne die Anwesenheit von Leerstellen die Präzipitatbildung sehr unwahrscheinlich wird und / oder sehr lange dauert. Die mittels des erläuterten Verfahrens hergestellte präzipitatarme Halbleiterzone 103 des Wafers eignet sich somit insbesondere auch zur Realisierung aktiver Bauelement zonen, insbesondere solcher Bauelementzonen, die in Leistungshalbleiterbauelementen dazu dienen, eine Sperrspannung des Bauelements aufzunehmen. Bei vertikalen Leistungshalbleiterbauelementen kann der zweite Halbleiterbereich 104, der eine hohe Präzipitatdichte aufweist, nach Beendigung der Vorderseitenprozesse entfernt werden und anschließend können die sogenannten Rückseitenprozesse, die für die Fertigstellung des Halbleiterbauelements erforderlich sind, durchgeführt werden. Bei lateralen Bauelementen, bei denen eine Stromflussrichtung in lateraler Richtung des Halbleiterkörpers verläuft, kann der zweite Halbleiterbereich auch verbleiben.

Es sei darauf hingewiesen, dass die Bestrahlung des Halbleiterkörpers mit hochenergetischen Teilchen und der erste Temperaturprozess zur Erzeugung der Leerstellen-Sauerstoff-Zentren nicht in unmittelbarer zeitlicher Abfolge erfolgen müssen. Wie noch erläutert werden wird, besteht insbesondere die Möglichkeit, vor Durchführen des zuvor als "erster Temperaturprozess" bezeichneten Prozesses, einen oder mehrere Temperaturprozesse bei niedrigerer Temperatur durchzuführen, die zur Stabilisierung der sich nach der Bestrahlung einstellenden Zustände in dem Wafer dienen.

Die dem Bestrahlungsprozess nachfolgenden Temperaturprozesse können dedizierte Temperaturprozesse sein, die nur zur Bildung der Leerstellen-Sauerstoff-Zentren bzw. zur Stabilisierung durchgeführt werden. Diese Temperaturprozesse können jedoch auch Temperaturprozesse sein, die einem weiteren Zweck, beispielsweise der Herstellung von Bauelementstrukturen in dem Wafer dienen. Solche Temperaturprozesse sind beispielsweise Temperaturprozesse zur Aktivierung von Dotierstoffen nach einer Dotierstoffimplantation, Temperaturprozesse zur Eindiffusion von Dotierstoffatomen in den Wafer oder Temperaturprozesse zur gezielten Oxidation von Bauelementstrukturen.

Der Bestrahlungsprozess und die Temperaturprozesse zur Herstellung der Leerstellen-Sauerstoff-Zentren bzw. zur Stabilisierung müssen außerdem nicht in enger zeitlicher Abfolge stattfinden. So besteht insbesondere die Möglichkeit, den Bestrahlungsprozess noch beim Wafer- bzw. Grundmaterialhersteller durchzuführen und einen oder mehrere Temperaturprozesse erst beim Bauelementhersteller, der einzelne Bauelemente aus dem Wafer fertigt, durchzuführen. Die Temperaturprozesse können hierbei wie bereits erläutert - in Fertigungsprozesse des Bauelementherstellers eingebunden sein und zur Bauelementherstellung ohnehin erforderliche Temperaturprozesse sein. An dem durch den Waferhersteller bestrahlten und damit für die Bauelementherstellung bereits vorbereiteten Wafer sind dann keine zusätzlichen dedizierten Prozesse für die Bildung der Leerstellen-Sauerstoff-Zentren erforderlich sind. Der einzige, gegenüber herkömmlichen Verfahren zusätzliche Verfahrensschritt besteht dann in der Bestrahlung des Wafers mit hochenergetischen Teilchen.

Die Dauer des ersten Temperaturprozesses, bei dem der Wafer auf Temperaturen zwischen 700° C und 1100° C aufgeheizt wird, kann zwischen einer Stunde und mehr als 20 Stunden betragen. Die Temperatur beträgt vorzugsweise zwischen 780° C und 1020° C, wobei vorzugsweise ein oder zwei Temperaturplateaus bei unterschiedlicher Temperatur eingestellt werden.

Bei einer Ausführungsform ist vorgesehen, den Wafer während des ersten Temperaturprozesses zunächst für eine erste Zeitdauer, die kürzer ist als 10 Stunden, auf eine Temperatur zwischen 780° C und 810° C und anschließend für eine zweite Zeitdauer, die länger ist als 10 Stunden, auf eine Temperatur zwischen 980° C und 1020° C aufzuheizen. Die erste Zeitdauer beträgt beispielsweise 5 Stunden, während die zweite Zeitdauer beispielsweise 20 Stunden beträgt.

Optional besteht die Möglichkeit, vor dem "Hochtemperaturverfahren", bei dem der Wafer 100 auf Temperaturen zwischen 700° C und 1100° C aufgeheizt wird, einen "Niedertemperaturprozess" bei niedrigeren Temperaturen zwischen 350 °C und 450 °C und einer Dauer zwischen 5 Stunden und 20 Stunden durchzuführen. Dieser Niedertemperaturschritt eignet sich für die Ausbildung stabiler Nukleationskeime für Sauerstoffpräzipitate. Die Temperaturschritte zur Erzeugung der präzipitatarmen Zone finden vorzugsweise in einer Inertgasatmosphäre statt.

Das Maximum der durch die Teilchenbestrahlung hergestellten Leerstellenkonzentration in dem Halbleiterwafer lässt sich bei dem erläuterten Verfahren über die Bestrahlungsbedingungen, d. h. insbesondere über die Art der verwendeten Teilchen und die Bestrahlungsenergie mit der die Teilchen eingestrahlt werden, vergleichsweise exakt einstellen.

Figur 1D zeigt qualitativ die Leerstellenverteilung in dem Halbleiterwafer 100 bei einer Bestrahlung des Wafers mit hochenergetischen Teilchen über dessen Rückseite 102. Die maximale Leerstellenkonzentration liegt dabei im sogenannten End-Of-Range-Bereich der Bestrahlung. Das ist der Bereich, bis zu dem die Bestrahlungsteilchen ausgehend von der Rückseite 102 in den Wafer 100 eindringen. Mit a ist in Figur 1D der Abstand zur Rückseite 102 des Wafers bezeichnet, al bezeichnet den Abstand der maximalen Leerstellenkonzentration ausgehend von der Rückseite 102. Diese Position al der maximalen Leerstellenkonzentration ist von der Bestrahlungseriergie abhängig und liegt bei einer Protonenimplantation mit einer Implantationsenergie von 2,25 MeV im Bereich zwischen 55 und 60 µm ausgehend von der Rückseite 102. Die Bestrahlung mit Protonen kann insbesondere senkrecht oder auch unter einem Neigungswinkel gegenüber der Rückseite 102, beispielsweise unter einem Winkel zwischen 5° und 10°, erfolgen.

Bei einer Protonenimplantationsdosis von 10¹⁴ cm⁻² liegt die maximale Leerstellenkonzentration im End-Of-Range-Bereich bei etwa 7·10¹⁸ Leerstellen/cm³. In dem zwischen dem End-Of-Range-Bereich und der Rückseite angeordneten, von den Protonen durchstrahlten Halbleiterbereich liegt die Leerstellenkonzentration bei der oben genannten Implantationsdosis im Bereich von etwa 5·10¹⁷ Leerstellen/cm³.

Die Abmessungen der präzipitatarmen Halbleiterzone 103 in vertikaler Richtung des Wafers sind ebenfalls abhängig von den Bestrahlungsbedingungen, insbesondere der Bestrahlungsenergie. Die präzipitatarme Halbleiterzone 103 entsteht bei dem erläuterten Verfahren in dem Bereich, in dem keine zusätzlichen Leerstellen durch die Teilchenbestrahlung erzeugt werden. Die Leerstellenreduktion in dem ersten Halbleiterbereich kann während des ersten Temperaturprozesses dabei umso effektiver erfolgen, je geringer die Abmessungen des ersten Halbleiterbereichs 103 in vertikaler Richtung sind bzw. je höher die Leerstellenkonzentration in dem zweiten Halbleiterbereich und je größer die vertikale Ausdehnung des zweiten Halbleiterbereiches 104 ist. Vorzugsweise erfolgt die Teilchenbestrahlung derart, dass der End-Of-Range-Bereich der Bestrahlung möglichst nahe an der zu erzeugenden präzipitatarmen, sich an die Vorderseite 101 anschließenden Halbleiterzone 103 liegt. Übliche Bestrahlungsenergien liegen im Bereich von 2...5...10 MeV bei Dicken des Wafers zwischen 400...700...1000 µm. Es sind aber auch geringere Bestrahlungsenergien wie z.B. im Bereich von 70-200kev denkbar, um präzipitatreiche Zonen im Halbleiterkristall zu erzeugen.

Solche Bestrahlungsenergien können durch handelsübliche Implantationsanlagen erreicht werden.

Vor Durchführen der Teilchenbestrahlung kann der Wafer optional einem zweiten Temperaturprozess unterworfen werden, bei dem der Wafer in einer feuchten und/oder oxidierenden Atmosphäre auf Temperaturen größer als 1000° C aufgeheizt wird. Ein solches Vorgehen ist aus der eingangs erwähnten EP 0769809 Al bekannt und dient dazu, gezielt interstitielle Siliziumatome in den Wafer zu injizieren, wobei die Tiefe, bis zu der diese Siliziumatome injiziert werden, von der Dauer des Temperaturprozesses abhängig ist und umso größer ist, je länger dieser Temperaturprozess durchgeführt wird. Die Injektion dieser interstitiellen Siliziumatome führt insbesondere in den oberflächennahen Bereichen des Halbleiterwafers bereits zu einer Reduktion von Leerstellen, insbesondere zu einer Reduktion von Leerstellenagglomeraten und beseitigt sogenannte D-Defekte in dem Halbleiterwafer. Die Vortemperung des Halbleiterwafers mittels des zweiten Temperaturprozesses kann insbesondere dazu dienen, gleiche "Anfangszustände" mehrerer durch das erläuterte Verfahren bearbeiteter Wafer herzustellen, um dadurch bei gleichen Verfahrensbedingungen Wafer mit gleichen Eigenschaften zu erzeugen. Diesem Vorgehen liegt die Erkenntnis zugrunde, dass sich einzelne Wafer, die aus unterschiedlichen Einkristallen abgeschnitten sind, bezüglich ihrer Leerstellenkonzentrationen und bezüglich der sogenannten D-Defektverteilungen unterscheiden können. Durch diese Vorgehensweise können insbesondere vorherige Präzipitate aufgelöst werden, und die Leerstellenkonzentration im solchermaßen behandelten Halbleiterkristall kann abgesenkt werden, wodurch die Wahrscheinlichkeit für eine Präzipitatbildung bei nachfolgenden Hochtemperaturschritten stark reduziert wird.

Da solche gleichen definierten Ausgangsbedingungen insbesondere im Bereich der späteren präzipitatarmen Halbleiterzone erwünscht sind, genügt es, während dieser Vortemperung die Vorderseite 101 einer feuchten und/oder oxidierenden Umgebung auszusetzen, wobei bei Bedarf die Eindringtiefe der interstitiellen Siliziumatome auch auf die vertikale Ausdehnung der Halbleiterzone 103 beschränkt werden kann. Selbstverständlich besteht jedoch auch die Möglichkeit, beide Seiten 101, 102 des Wafers während dieser Vortemperung einer feuchten und/oder oxidierenden Atmosphäre auszusetzen.

Optional besteht außerdem die Möglichkeit, den Wafer nach oder vor Durchführen des ersten Temperaturprozesses, durch den die Nukleationszentren und Sauerstoffagglomerate erzeugt werden, einem weiteren Temperaturprozess zu unterziehen, bei dem wenigstens die erste Halbleiterzone 103 derart aufgeheizt wird, dass Sauerstoffatome aus dieser ersten Halbleiterzone über die Vorderseite 101 des Wafers ausdiffundieren. Die Temperaturen dieses weiteren Temperaturprozesses liegen beispielsweise im Bereich zwischen 900°C und 1250°C. Durch diesen weiteren Temperaturprozess wird die Sauerstoffkonzentration in der präzipitatarmen Halbleiterzone 103 weiter reduziert, was die Wahrscheinlichkeit für das Entstehen von Sauerstoffpräzipitaten in dieser Halbleiterzone während nachfolgender Temperaturprozesse weiter reduziert. Darüber hinaus reduziert die Sauerstoffreduktion in der präzipitatarmen Halbleiterzone die Gefahr einer Entstehung.sogenannter thermischer Donatoren. Solche thermischen Donatoren können in einem Kristallgitter bei Vorhandensein interstitiellen Sauerstoffs und bei Temperaturprozessen mit Temperaturen zwischen 400° C und 500° C entstehen.

Alle zuvor erläuterten Temperaturprozesse können als herkömmlichte Of enprozesse realisiert werden, bei denen der Wafer in einem Ofen auf die gewünschte Temperatur aufgeheizt wird. Die Temperaturprozesse können darüber hinaus auch als RTA-Prozesse (RTA = Rapid Thermal Annealing) durchgeführt werden, bei denen der Wafer beispielsweise mittels einer Lampe oder eines Laserstrahls, aufgeheizt wird.

Zur Erzeugung der Kristalldefekte in der zweiten Halbleiterzone 104' besteht außerdem die Möglichkeit, mehrere Implantationsschritte mit unterschiedlichen Implantationsenergien durchzuführen. Hierbei besteht zudem die Möglichkeit, mehrere erste Temperaturprozesse derart durchzuführen, dass zwischen zwei Implantationsprozessen ein erster Temperaturprozess bei den genannten Temperaturen durchgeführt wird.

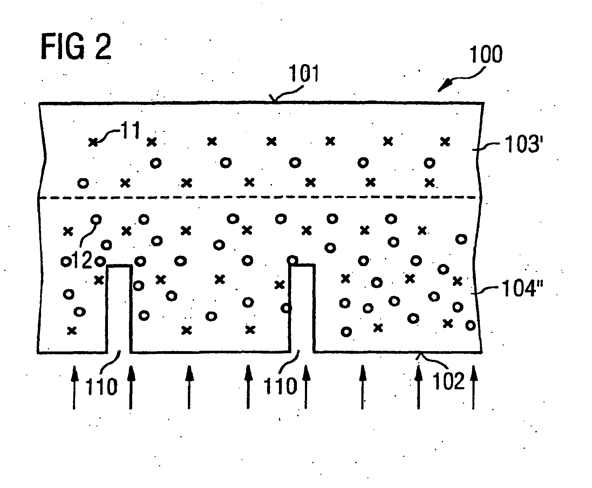

Bezug nehmend auf Figur 2 besteht die Möglichkeit, vor Durchführen der Teilchenbestrahlung ausgehend von der Rückseite 102 Gräben 110 in den Halbleiterkörper einzubringen. Während des nachfolgenden Bestrahlungsschrittes dringen die hochenergetischen Teilchen sowohl über die Rückseite 102 als auch über die Gräben 110 in den zweiten Halbleiterbereich 104 des Wafers ein. Die Gräben bieten eine weitere Möglichkeit, die Eindringtiefe der hochenergetischen Teilchen in den Halbleiterwafer 100 zu beeinflussen.

Außer der Durchführung einer Teilchenbestrahlung zur Erzeugung von Gitterleerstellen in dem zweiten Halbleiterbereich 104 besteht zur Erzeugung dieser Leerstellen auch die Möglichkeit, den Halbleiterwafer einem Temperaturprozess zu unterziehen, bei dem die Rückseite 102 des Wafers einer nitridierenden Atmosphäre ausgesetzt wird, während die Vorderseite, beispielsweise durch Aufbringen eines Oxids, vor einer solchen nitridierenden Atmosphäre geschützt wird. Der Temperaturprozess in der nitridierenden Atmosphäre bewirkt eine Erzeugung von Gitterleerstellen in dem zweiten Halbleiterbereich 104, wobei die erreichbare Leerstellenkonzentration allerdings niedriger ist als bei der zuvor erläuterten Teilchenbestrahlung. Während des Temperaturprozesses zur Herstellung dieser Leerstellen wird der Wafer vorzugsweise rasch aufgeheizt, beispielsweise mittels eines RTA-Schrittes, und dann vergleichsweise langsam abgekühlt, was in der eingangs erwähnten US 6,849,119 B2 erläutert ist. Die Herstellung von Gitterleerstellen durch einen Temperaturprozess in einer nitridierenden Atmosphäre eignet sich insbesondere in Verbindung mit der anhand von Figur 2 erläuterten Herstellung von Gräben 110 ausgehend von der Rückseite 102 des Halbleiterwafers.

Das zuvor erläuterte Verfahren zur Herstellung einer präzipitatarmen Halbeiterzone eignet sich auch zur Herstellung einer präzipitatarmen Halbleiterzone in dem Halbleitersubstrat eines SOI-Substrats. Ein solches SOI-Substrat weist bekanntlich ein Halbleitersubstrat, eine auf dem Halbleitersubstrat angeordnete Isolationsschicht und eine auf der Isolationsschicht angeordnete Halbleiterschicht auf. Ein solches Substrat kann z. B. hergestellt werden, indem eine Schichtanordnung mit der Isolationsschicht und der Halbleiterschicht auf das Halbleitersubstrat mittels eines Waferbondverfahrens gebondet wird. Das Halbleitersubstrat kann dabei insbesondere ein CZ-Wafer sein.

In Figur 1A sind eine Isolationsschicht 302 und eine Halbleiterschicht 301, die den CZ-Wafer zu einem SOI-Substrat ergänzen, gestrichelt dargestellt. Mittels des zuvor erläuterten Verfahrens lässt sich eine präzipitatarme Halbleiterzone in dem Wafer 100 in einem Bereich anschließend an die Isolationsschicht 302 erzeugen. Besonders vorteilhaft ist dieses Vorgehen, wenn in dem an die Isolierschicht angrenzenden Bereich des SOI-Substrats bei Betrieb des Bauelements ein elektrisches Feld aufgebaut wird. Bislang musste dieser Bereich als epitaktisch abgeschiedene Halbleiterschicht ausgeführt werden, um z. B. den durch Generation verursachten Sperrstrom innerhalb tolerabler und eng tolerierter Grenzen zu halten. Auf die Erzeugung dieser aufwändigen und teuren Epitaxieschicht kann dank des erläuterten Verfahrens verzichtet werden, oder eine solche Epitaxieschicht kann zumindest deutlich dünner und somit kostengünstiger als bisher üblich ausgeführt werden.

Darüber hinaus kann auch die oberhalb der Isolationsschicht 302 vorhandene Halbleiterzone 301 als präzipitatarme Zone eines CZ-Grundmaterials unter Anwendung des erläuterten Verfahrens hergestellt werden. Hierzu wird eine weitere CZ-Halbleiterscheibe, die die spätere Zone 301 umfasst, dem erläuterten Verfahren unterzogen, so dass eine präzipitatarme, an eine Oberfläche der Scheibe angrenzende Zone entsteht. Diese weitere Scheibe wird dann auf das Halbleitersubstrat gebondet, wobei die präzipitatarme Zone der weiteren Scheibe dem Substrat 100 bzw. der Isolationsschicht 302 zugewandt ist. Eine präzipitatreiche Zone (nicht dargestellt) dieser weiteren Scheibe wird nach dem Waferbonden z.B. durch Schleifen und / oder Ätzen wieder entfernt.

Waferbondverfahren selbst sind grundsätzlich bekannt, so dass hierzu keine weitere Ausführungen erforderlich sind. Bei einem solchen Verfahren werden zwei zu verbindende Halbleiteroberflächen aufeinander gebracht, von den eine oder auch beide oxidiert sein können, wobei anschließend ein Temperaturprozess durchgeführt wird, um die beiden Oberflächen zu verbinden. Übliche Temperaturen hierfür liegen im Bereich zwischen 400° C und 1000° C

Das erläuterte Verfahren lässt sich auch sehr gut mit den sogenannten SIMOX-Technologien zur Herstellung eines SOI-Substrats kombinieren. D. h. zuerst wird mittels des erläuterten Verfahrens die präzipitatarme Zone 103 erzeugt und anschließend wird mittels einer Sauerstoffimplantation die Isolationsschicht in dieser Zone 103 erzeugt.

Der Halbleiterwafer, der nach der erläuterten Behandlung im Bereich seiner Vorderseite 101 eine präzipitatfreie oder zumindest präzipitatarme Halbleiterzone 103 aufweist, eignet sich insbesondere zur Realisierung vertikaler Leistungsbauelemente, wie dies nachfolgend noch erläutert werden wird. Der Wafer kann eine Grunddotierung, beispielsweise eine n-Grunddotierung besitzen, die bereits bei Ziehen des Einkristalls während des Czochralski-Verfahrens erzeugt wird. Die präzipitatarme Halbleiterzone 103 kann insbesondere zur Realisierung einer eine Sperrspannung des Leistungsbauelements aufnehmenden Halbleiterzone dienen.

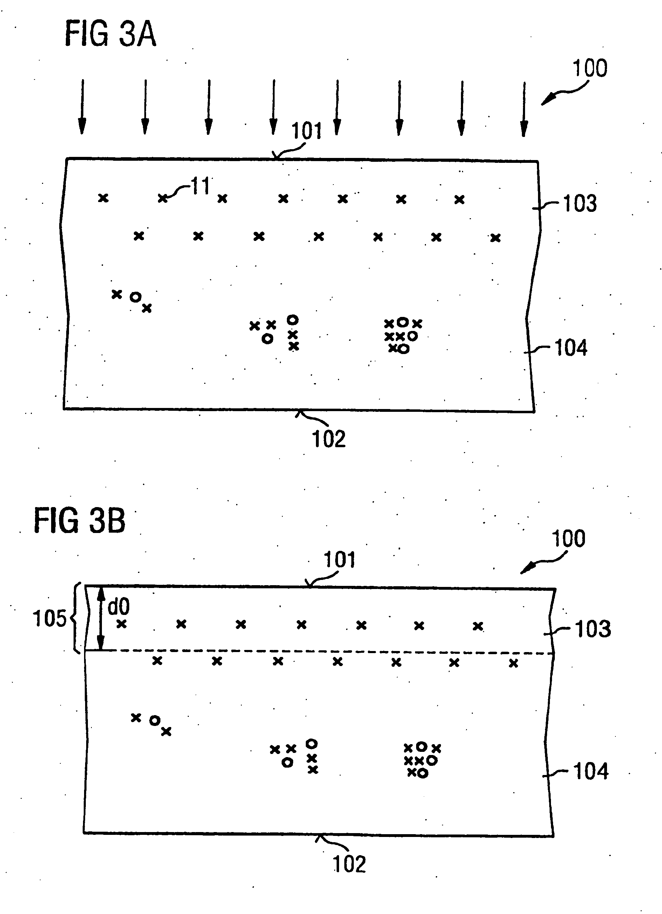

Anhand der Figuren 3A bis 3C wird nachfolgend ein Verfahren zur Herstellung einer n-dotierten Halbleiterzone in der präzipitatarmen Halbleiterzone 103 des CZ-Wafers 100 erläutert. Dieses Verfahren kann zusätzlich zur Herstellung einer n-Grunddotierung während des Ziehens des Einkristalls angewendet werden, kann jedoch auch zur Herstellung einer n-dotierten Halbleiterzone bei einem undotierten CZ-Wafer angewendet werden, die wie eine grunddotierte Zone wirkt, d. h. in vertikaler Richtung zumindest über einen großen Teil ihrer vertikalen Ausdehnung eine annähernd konstante Dotierung aufweist. Letzteres ist insbesondere deshalb vorteilhaft, weil die Herstellung einer Grunddotierung des Wafers während des Ziehens des Einkristalls aufgrund der vorhandenen Sauerstoffpräzipitate zu nicht zufriedenstellenden Ergebnissen, insbesondere zu einer inhomogenen und schlecht reproduzierbaren Dotierung führt.

Bezug nehmend auf Figur 3A ist bei diesem Verfahren vorgesehen, Protonen über die Vorderseite 101 in die präzipitatarme Halbleiterzone 103 des Wafers 100 zu implantieren. Die Implantationsrichtung kann dabei senkrecht zu der Vorderseite 101, kann jedoch auch unter einem Winkel gegenüber dieser Vorderseite 101 verlaufen. Durch die Protonenimplantation werden zum Einen Kristalldefekte in dem von Protonen durchstrahlten Bereich der präzipitatarmen Halbleiterzone 103 hervorgerufen. Darüber hinaus werden durch die Protonenimplantation Protonen in die präzipitatarme Halbleiterzone 103 eingebracht. Die Abmessungen einer Kristalldefekte aufweisenden, von Protonen durchstrahlten Zone in vertikaler Richtung ausgehend von der Vorderseite 101 sind dabei von der Implantationsenergie abhängig. Die Abmessungen dieser Zone sind dabei umso größer sind, je höher die Implantationsenergie ist, je tiefer also die Protonen über die Vorderseite 101 in den Wafer 100 eindringen.

An die Protonenbestrahlung schließt sich ein Temperaturprozess an, bei dem der Wafer 100 wenigstens im Bereich der mit Protonen bestrahlten Zone auf Temperaturen zwischen 400° C und 570° C aufgeheizt wird, wodurch aus den durch die Protonenbestrahlung erzeugten Kristalldefekten und den eingebrachten Protonen wasserstoffinduzierte Donatoren entstehen. Die Temperatur während dieses Temperaturprozesses liegt vorzugsweise im Bereich zwischen 450° C und 550° C.

Durch die Protonenimplantation werden die Protonen hauptsächlich in den End-Of-Range-Bereich der Bestrahlung eingebracht. Die Position dieses Bereichs ausgehend von der Vorderseite 101 ist von der Implantationsenergie abhängig. Der End-Of-Range-Bereich bildet das "Ende" des durch die Protonenimplantation bestrahlten Gebietes in vertikaler Richtung des Wafers 100. Die Bildung wasserstoffinduzierter Donatoren setzt - wie bereits erläutert - das Vorhandensein von geeigneten Kristalldefekten und das Vorhandensein von Protonen voraus. Die Dauer des Temperaturprozesses ist vorzugsweise so gewählt, dass die hauptsächlich in den End-Of-Range-Bereich eingebrachten Protonen in nennenswertem Umfang in Richtung der Vorderseite 101 diffundieren, um dadurch eine möglichst homogene n-Dotierung in dem durchstrahlten Bereich der präzipitatarmen Halbleiterzone 103 zu erzeugen. Die Dauer dieses Temperaturprozesses liegt zwischen einer Stunde und 10 Stunden, vorzugsweise zwischen 3 und 6 Stunden.

Ergebnis des Temperaturprozesses ist Bezug nehmend auf Figur 3B eine n-dotierte Halbleiterzone 105 in der präzipitatarmen Halbleiterzone 103 des Wafers 100. Die n-Halbleiterzone 105 erstreckt sich ausgehend von der Vorderseite 101 bis zu einer Tiefe d0 in den Wafer 100 hinein, wobei diese Tiefe in erläuterter Weise von der Implantationsenergie abhängig ist.

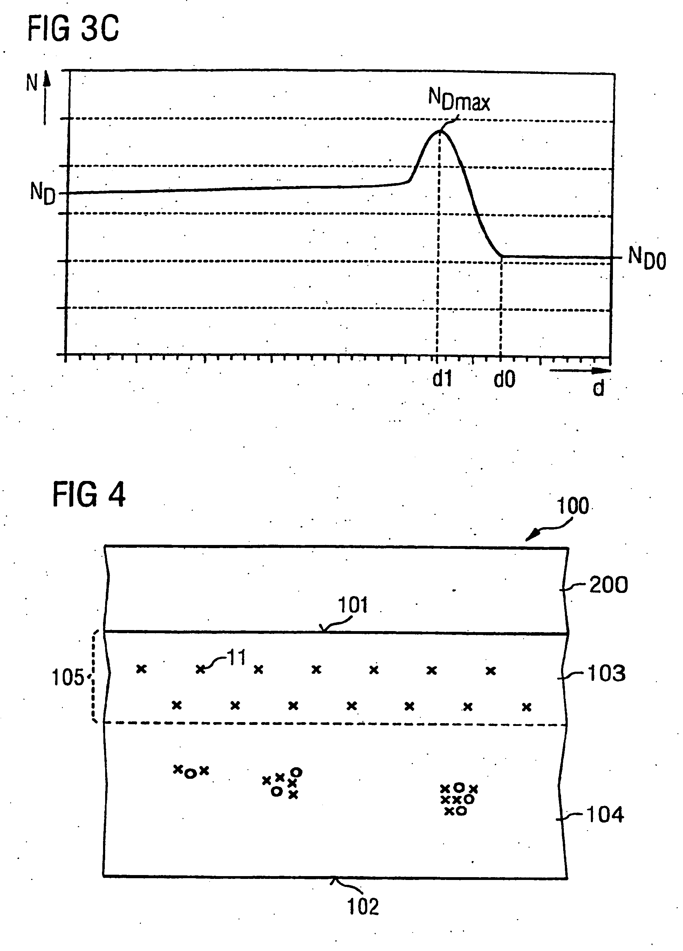

Figur 3C zeigt ein Beispiel für ein Dotierprofil dieser n-Halbleiterzone 105. In Figur 3C ist die Dotierungskonzentration ausgehend von der Vorderseite 101 aufgetragen. Mit N_{D0} ist hierbei die Grunddotierung des Wafers 100 vor Durchführung des Dotierverfahrens bezeichnet.

Wie Figur 3C zu entnehmen ist, weist die n-Halbleiterzone 105 ausgehend von der Vorderseite 101 einen annähernd homogenen Dotierungsverlauf mit einer Dotierungskonzentration N_{D} auf, die in einem Endbereich der n-Halbleiterzone 105 auf eine maximale Dotierungskonzentration N_{Dmax} ansteigt und danach auf die Grunddotierung N_{D0} absinkt. Der Endbereich der n-Halbleiterzone, in dem die Dotierung zunächst ansteigt und dann auf die Grunddotierung absinkt, resultiert aus dem End-Of-Range-Bereich der Protonenimplantation, in den während der Implantation der Großteil der Protonen eingelagert werden. In Folge des Temperaturprozesses diffundiert ein großer Teil der Protonen in Richtung der Vorderseite 101, woraus die homogene Dotierung N_{D} in dem von den Protonen durchstrahlten Bereich resultiert. Die in die Tiefe des Halbleiters in Richtung der Rückseite 102 diffundierenden Protonen führen in diesem Bereich nicht zur Bildung von Donatoren, da dort keine implantationsinduzierten Kristalldefekte, die zur Bildung von Donatoren erforderlich sind, vorhanden sind. Die Differenz zwischen der maximalen Dotierungskonzentration N_{Dmax} im End-Of-Range-Hereich und der homogenen Dotierungskonzentration N_{D} in dem durchstrahlten Bereich ist maßgeblich abhängig von der Temperatur während des Temperaturprozesses und der Dauer des Temperaturprozesses. Hierbei gilt, dass bei gleicher Dauer des Temperaturprozesses diese Differenz umso geringer ist, je höher die Temperatur während des Temperaturprozesses ist, und dass bei einer gegebenen Temperatur während des Temperaturprozesses die Differenz umso geringer ist, je länger die Dauer des Temperaturprozesses ist. Bei ausreichend hoher Temperatur und ausreichend langer Dauer des Temperaturprozesses kann diese Differenz auch gegen Null gehen bzw. sehr klein werden.

Bei einem Ausführungsbeispiel ist vorgesehen, dass der Temperaturprozess so gewählt ist, dass die durch die Protonenimplantation und die anschließende Temperaturbehandlung erzeugte n-Halbleiterzone 105 einen Bereich mit wenigstens annähernd homogener Dotierung aufweist, der sich in vertikaler Richtung des Halbleiterkörpers 100 wenigstens über 60%, besser über 80%, der Ausdehnung der n-Halbleiterzone 105 erstreckt, wobei als vertikale Ausdehnung ein Abstand zwischen der Oberfläche, über die implantiert wurde, und dem sogenannten End-Of-Range der Implantation angenommen wird. Der End-Of-Range bezeichnet hierbei die Position, an der unmittelbar nach der Implantation die Protonenkonzentration am größten ist. Unter einer "wenigstens annähernd homogenen Dotierung" ist in diesem Zusammenhang zu verstehen, dass das Verhältnis zwischen maximaler Dotierungskonzentration und minimaler Dotierungskonzentration in dem Bereich homogener Dotierung maximal 3 beträgt. Bei einer Ausführungsform ist vorgesehen, dass dieses Verhältnis maximal 2, bei weiteren Ausführungsformen ist vorgesehen, dass dieses Verhältnis maximal 1,5 oder 1,2 beträgt.
Das zuvor erläuterte Verfahren zur Herstellung der n-dotierten Halbleiterzone 105 in einer präzipitatarmen Halbleiterzone eines CZ-Wafer kann nach einem beliebigen Verfahren zur Erzeugung einer solchen präzipitatarmen Halbleiterzone durchgeführt werden.

Zur Herstellung einer präzipitatarmen Zone eignet sich neben dem zuvor erläuterten insbesondere das in der EP 0 769 809 A1 beschriebene Verfahren, bei dem ein CZ-Wafer in einer oxidierenden Atmosphäre bei Temperaturen zwischen 1100 °C und 1180 °C oxidiert für eine Dauer zwischen 2 Stunden und 5 Stunden oxidiert wird. Die Oxidation kann dabei in einer trockenen oder feuchten Atmosphäre erfolgen.

Die Oxidation kann insbesondere auch in einer Atmosphäre einer sauerstoffhaitigen gasförmigen Dotierstoffverbindung, wie z.B. POCl₃, erfolgen. Eine während einer solchen Oxidation zudem entstehende dotierte Schicht in einem oberflächennahen Bereich des Wafers wird nach Durchführung des Oxidationsschrittes, ebenso wie eine sich auf der Oberfläche bildende Oxidschicht, entfernt.

Ein solches Oxidationsverfahren kann außerdem mit dem zuvor erläuterten, einen Bestrahlungsprozess und wenigstens einen Temperaturprozess umfassenden verfahren kombiniert werden, indem nach Durchführung des Oxidationsverfahrens der Bestrahlungs- und Temperaturprozess durchgeführt werden.

Die Durchführung des Oxidationsverfahren, sei es als einziges Verfahren zur Herstellung der präzipitatarmen Zone oder in Kombination mit dem Bestrahlungs- und Temperaturprozess führt unvermeidlich zur Ausbildung einer Oxidschicht auf der Oberfläche des Wafers, die vor der Durchführung weiterer Verfahrensschritte, die für die Realisierung von Bauelementen in dem Wafer erforderlich sind, bei Bedarf entfernt wird.

Das Entfernen der Oxidschicht kann beispielsweise mittels eines Ätzverfahrens erfolgen. Die Oxidation der Waferoberfläche und das Ätzen der Oxidschicht führen allerdings zu einem Aufrauen der Waferoberfläche in einem Maß, das zumindest für die weitere Herstellung integrierter Schaltungen (ICs) ungeeignet ist. Nach Entfernen der Oxidschicht wird die Oberfläche des Wafers daher vorzugsweise poliert, bevor weitere Verfahrensschritte, beispielsweise die Verfahrensschritte zur Herstellung der n-dotierten Zone 105 und/oder Verfahrensschritte zur Realisierung von Bauelementen, durchgeführt werden.

Die mittels des zuvor erläuterten Verfahrens hergestellte, eine n-Dotierung mit wasserstoffinduzierten Donatoren aufweisende Halbleiterzone 105 eignet sich insbesondere zur Realisierung einer eine Sperrspannung aufnehmenden Halbleiterzone eines Leistungsheibleiterbauelements. Eine solche Zone ist beispielsweise die Driftzone eines MOSFET, die Driftzone bzw. n-Basis eines IGBT oder die Driftzone bzw. n-Basis einer Diode.

Die Herstellung der n-Halbleiterzone 105 kann insbesondere auch derart erfolgen, dass das Maximum der Dotierungskonzentration in dem Sauerstoffagglomerate aufweisenden Bereich 104 liegt, so dass die präzipitatarme Zone 103 infolge des Dotierungsverfahrens eine homogene n-Dotierung erhält.

Zu dem anhand der Figuren 1A bis 1C erläuterten Behandlungsverfahren ist anzufügen, dass bei diesem Verfahren bei Verwendung von Protonen als hochenergetische Teilchen keine wasserstoffinduzierten Donatoren gebildet werden, da die bei diesem Verfahren angewendeten Temperaturen zwischen 700° C und 1100° C zu hoch für die Erzeugung wasserstoffinduzierter Donatoren sind.

Zur Vorbereitung des Wafers 100 für die Herstellung von Leistungshalbleiterbauelementen kann optional Bezug nehmend auf Figur 4 eine einkristalline Epitaxieschicht 200 auf der Vorderseite 101 oberhalb der präzipitatarmen Halbleiterzone 103 erzeugt werden. Die Dotierungskonzentration dieser Epitaxieschicht 200 wird vorzugsweise an die Dotierungskonzentration der präzipitatarmen Halbleiterzone 103 bzw. der in der präzipitatarmen Halbleiterzone 103 vorhandenen n-dotierten Halbleiterzone 105 und darüber hinaus an die Anforderungen an das Bauelement angepasst. Die Einstellung der Dotierungskonzentration der Epitaxieschicht 200 erfolgt in bekannter Weise während des Abscheideverfahrens dieser Epitaxieschicht oder optional auch durch eine Protonenbestrahlung in Kombination mit einer geeigneten Temperung gemäß dem zuvor erläuterten Verfahren.

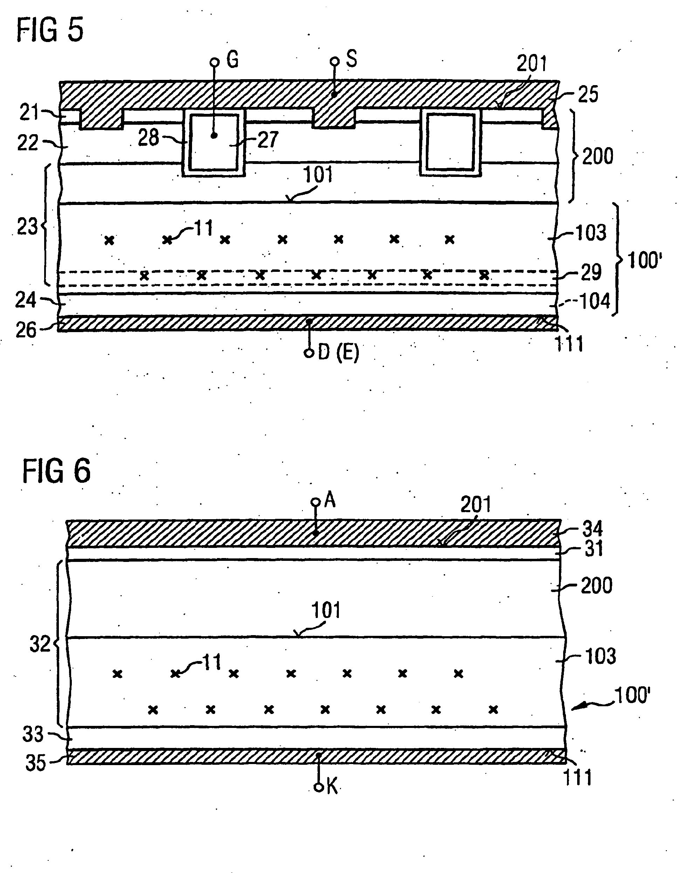

Der mittels der zuvor erläuterten Behandlungsverfahren bearbeitete Halbleiterwafer 100 eignet sich zur Herstellung von vertikalen Leistungshalbleiterbauelementen, was nachfolgend anhand der Figuren 5 und 6 erläutert wird.

Das Ausgangsmaterial für die Leistungshalbleiterbauelemente bildet der Wafer 100, auf den optional eine anhand von Figur 4 erläuterte Epitaxieschicht 200 aufgebracht sein kann. Für die nachfolgende Erläuterung wird vom Vorhandensein einer solchen Epitaxieschicht 200 ausgegangen. Es sei jedoch darauf hingewiesen, dass auf diese Epitaxieschicht 200 auch verzichtet werden kann, insbesondere dann, wenn die präzipitatarme Halbleiterzone 103 in vertikaler Richtung des Wafers 100 eine ausreichend große Abmessung zur Realisierung aktiver Bauelementzonen, insbesondere zur Realisierung von eine Sperrspannung aufnehmenden Bauelementzonen des Leistungshalbleiterbauelements aufweist.

Figur 5 zeigt in Seitenansicht im Querschnitt einen vertikalen Leistungs-MOSFET, der auf Basis eines nach dem zuvor erläuterten Verfahren behandelten CZ-Wafer 100 hergestellt wurde. Der MOSFET weist einen Halbleiterkörper auf, der durch einen Abschnitt 100' des behandelten Wafers (100 in den Figuren 1 bis 4) und in dem Beispiel durch eine auf den Wafer aufgebrachte Epitaxieschicht 200 gebildet ist. Das Bezugszeichen 201 bezeichnet in dem Beispiel eine Vorderseite der Epitaxieschicht, die gleichzeitig die Vorderseite des Halbleiterkörpers bildet. Der Waferabschnitt 100' ist in nicht näher dargestellter Weise durch Abtragen des Wafers 100 ausgehend von dessen Rückseite (Bezugszeichen 102 in den Figuren 1 bis 4) entstanden. Das Bezugszeichen 111 bezeichnet die nach dem Abtragen vorhandene Oberfläche dieses Waferabschnitts 100', die gleichzeitig die Rückseite des Halbleiterkörpers bildet.

Der MOSFET ist in dem Beispiel als vertikaler Trench-MOSFET ausgebildet und weist eine Source-Zone 21, eine sich an die Source-Zone 21 in vertikaler Richtung anschließende Body-Zone 22, eine sich an die Body-Zone 22 in vertikaler Richtung anschließende Driftzone 23 sowie eine sich an die Driftzone 23 in vertikaler Richtung anschließende Drain-Zone 24 auf. Die Source-Zone 21 und die Body-Zone 22 sind bei dem in Figur 5 dargestellten Bauelement in der Epitaxieschicht 200 angeordnet.

Zur Steuerung eines Inversionskanals in der Body-Zone 22 ist eine Gate-Elektrode 27 vorhanden, von der in Figur 5 zwei Elektrodenabschnitte dargestellt sind und die in einem Graben angeordnet ist, der sich ausgehend von der Vorderseite 201 in vertikaler Richtung in den Halbleiterkörper hineinerstreckt. Die Gate-Elektrode 27 ist mittels eines Gate-Dielektrikums 28, üblicherweise einer Oxidschicht gegenüber dem Halbleiterkörper dielektrisch isoliert. Die Herstellung der Source- und Body-Zonen 21, 22 kann in bekannter Weise mittels Implantations- und Diffusionsschritten erfolgen. Die Herstellung der Gate-Elektrode erfolgt durch Ätzen des Grabens, Aufbringen einer Gate-Dielektrikumsschicht in dem Graben und Abscheiden einer Elektrodenschicht in dem Graben.

Die Source-Zone 21 ist durch eine Source-Elektrode 25 kontaktiert, die sich abschnittsweise in vertikaler Richtung des Halbleiterkörpers bis in die Body-Zone 22 erstreckt, um dadurch die Source-Zone 21 und die Body-Zone 22 in bekannter Weise kurzzuschließen. Die Drain-Zone 24 ist durch eine auf die Rückseite 111 aufgebrachte Drain-Elektrode 26 kontaktiert.

Die Driftzone 23 des MOSFET ist abschnittsweise durch die Epitaxieschicht 20 und abschnittsweise durch die präzipitatarme Halbleiterzone 103 des Waferabschnitts 100' gebildet. Die Drain-Zone 24 ist eine im Vergleich zur Driftzone 23 hochdotierte Halbleiterzone, die beispielsweise durch Implantation von Dotierstoffatomen über die Rückseite 111 hergestellt werden kann. Die Drain-Zone 24 kann dabei vollständig in der präzipitatarmen Halbleiterzone 103 angeordnet sein, kann jedoch auch in einem nach dem Zurückätzen oder Zurückschleifen verbliebenen Abschnitt der Sauerstoffagglomerate enthaltenden Halbleiterzone (Bezugszeichen 104 in den Figuren 1 bis 3) angeordnet sein. Maßgeblich für ein ordnungsgemäßes Funktionieren des Bauelements ist hierbei, dass die Driftzone, die dazu dient, bei sperrendem Bauelement eine anliegende Sperrspannung aufzunehmen, nur durch Abschnitte der präzipitatarmen Halbleiterzone 103 gebildet ist. Andernfalls würden in der Driftzone 23 vorhandene Sauerstoffagglomerate die Leistungsfähigkeit des Bauelements, insbesondere dessen Spannungsfestigkeit und Leckstromverhalten degradieren.

Die Spannungsfestigkeit des dargestellten Leistungs-MOSFET ist maßgeblich abhängig von den Abmessungen der Driftzone 23 in vertikaler Richtung und darüber hinaus von der Dotierungskonzentration dieser Driftzone. Der Waferabschnitt 100', der nach dem Zurückschleifen des Wafers während des Bauelementherstellverfahrens verbleibt, kann ausschließlich die zuvor erzeugte präzipitatarme Halbleiterzone 103 umfassen, kann jedoch im Bereich der Rückseite 102 auch Abschnitte der Sauerstoffagglomerate 104 aufweisenden Zone umfassen, wobei diese Sauerstoffagglomerate aufweisende Zone dann lediglich zur Realisierung der hochdotierten Drain-Zone 24 und nicht zur Realisierung der eine Sperrspannung aufnehmenden Driftzone 23 dienen darf.

Auf das Aufbringen einer Epitaxieschicht 200 kann insbesondere dann verzichtet werden, wenn die Abmessungen der präzipitatarmen Halbleiterzone 103 in vertikaler Richtung ausreichend groß sind, um eine Driftzone mit einer für eine gewünschte Spannungsfestigkeit ausreichenden Dicke zu realisieren.

Der dargestellte vertikale Leistungs-MOSFET ist insbesondere ein n-Leistungs-MOSFET. In diesem Fall sind die Source-Zone 21, die Driftzone 23 und die Drain-Zone 24 n-dotiert, während die Body-Zone 22 p-dotiert ist. Selbstverständlich ist basierend auf dem mittels des zuvor erläuterten Verfahrens behandelten Wafer auch ein p-Leistungs-MOSFET realisierbar, dessen Bauelementzonen im Vergleich zu einem n-Leistungs-MOSFET komplementär dotiert sind.

Die Dotierung der Driftzone 23 kann gemäß dem zuvor erläuterten Verfahren mittels einer Protonenimplantation in die Scheibenvorderseite und einem anschließenden Temperschritt erzeugt werden. Diese Schritte zur Dotierung der Driftzone 23 erfolgen vorzugsweise erst nach der Herstellung der Source-und Body-Zonen 21, 22 und des Gate-Oxids 28, da diese Herstellschritte Temperaturen erfordern, die weit oberhalb von 600° C liegen sodass eine Protonen-induzierte Dotierung verschwinden würde. Herstellschritte, die Temperaturen unterhalb von etwa 430° C erfordern - wie z.B. die Temperung der Metallisierung oder von abgeschiedenen Polyimidschichten - können dagegen später, d.h. nach der Dotierung der Driftzone 23, erfolgen. Dabei kann das, Temperaturbudget der nachfolgenden Herstellschritte auf das Temperaturbudget beim Tempern der Protonen-induzierten Dotierung der Driftzone 23 angerechnet werden. Eine solche weitere Temperung kann dann entsprechend kürzer durchgeführt werden oder sogar vollständig entfallen.

Auf Basis des behandelten Wafergrundmaterials lassen sich auch bipolare Leistungsbauelemente, wie beispielsweise ein Trench-IGBT realisieren. Die Struktur eines solchen Trench-IGBT entspricht der Struktur des in Figur 5 dargestellten vertikalen Leistungs-MOSFET, mit dem Unterschied, dass anstelle einer den gleichen Leitungstyp wie die Driftzone 23 aufweisenden Drain-Zone 24 eine komplementär zu der Driftzone 23 dotierte Emitterzone 24 vorhanden ist.

Bei einem IGBT kann der Emitterzone 24 in der Driftzone 23 eine Feldstoppzone 29 vorgelagert sein, die vom gleichen Leitungstyp wie die Driftzone 23, jedoch höher als die Driftzone 23 dotiert ist. Diese Feldstoppzone 29 kann sich an die Emitterzone 24 anschließen, kann jedoch auch beabstandet zu der Emitterzone 24 angeordnet sein. Die Feldstoppzone 29 liegt jedoch näher an der Emitterzone 24 als an der Body-Zone 22.

Die Herstellung einer solchen Feldstoppzone 29 in dem CZ-Wafer 100 kann mittels einer Protonenimplantation und einem anschließenden Temperaturschritt erfolgen. Die Protonenimplantation kann dabei insbesondere über die Rückseite 102 des Wafers 100 erfolgen. Der Abstand der Feldstoppzone 29 zu der Rückseite ist dabei von der verwendeten Implantationsenergie abhängig. Um die Abmessungen der Feldstoppzone in vertikaler Richtung des Wafers 100 und das sich ergebende Dotierungsprofil einstellen zu können, besteht die Möglichkeit, unterschiedliche Implantationsenergien einzusetzen, wobei die Implantationsdosis mit zunehmender Implantationsenergie vorzugeweise abnimmt.

Das Verfahren zur Herstellung der Feldstoppzone unterscheidet sich von dem Verfahren zur Herstellung der die n-Grunddotierung 105 aufweisenden Halbleiterzone durch die Dauer und/oder Temperatur des Temperaturschrittes. Bei der Herstellung der n-Zone 105 soll eine Diffusion der Protonen in einem nennenswerten Umfang in Richtung der Implantationsseite erreicht werden, um eine möglichst homogene Dotierung über einen in vertikaler Richtung möglichst breiten Bereich zu erhalten. Die Feldstoppzone 29 soll im Gegensatz dazu, in der vertikalen Richtung möglichst exakt begrenzt sein. Um dies zu erreichen, ist die Temperatur und/oder die Dauer des Temperaturschrittes zur Herstellung der Feldstoppzone 29 geringer als Temperatur und/oder Dauer bei Herstellung der n-Zone 105. Die Temperatur des Temperaturprozesses bei Herstellung der Feldstoppzone 29 liegt beispielsweise im Bereich zwischen 350 °C und 400 °C, die Dauer des Temperaturprozesses beträgt zwischen 30 Minuten und 2 Stunden.

Alternativ kann die Feldstoppzone vollständig oder zumindest teilweise während der Verfahrensschritte zur Herstellung der n-Grunddotierung erfolgen. Wie erläutert, werden zur Herstellung der n-Grunddotierung Protonen über die Vorderseite 101 in den Wafer implantiert. Diese Protonen diffundieren anschließend aus dem End-Of-Range-Bereich unter dem Einfluss des Temperaturprozesses in Richtung der Vorderseite. Dieser Diffusionsprozess kann über die Dauer und die Temperatur des Temperaturprozesses so eingestellt werden, dass im End-Of-Range-Bereich eine höhere Dotierung entsteht als die n-Grunddotierung in dem zwischen dem End-Of-Range-Bereich und der Vorderseite gelegenen Zwischenbereich. Die Temperatur und/oder die Dauer des Temperaturprozesses zur Herstellung einer n-Grunddotierung bei gleichzeitiger Herstellung einer Feldstoppzone sind geringer als bei dem Prozess zur ausschließlichen Herstellung der n-Grunddotierung. Die Implantationsenergie der Protonenbestrahlung ist selbstverständlich so einzustellen, dass die Eindringtiefe der Protonen geringer ist als die Scheibendicke des Wafers.

Eine zusätzliche Dotierung der Feldstoppzone kann durch das oben erläuterte Verfahren, bei dem eine Protonenimplantation über die Rückseite durchgeführt wird, erreicht werden.

Die Driftzone 23 ist bei einem IGBT üblicherweise n-dotiert. Entsprechend sind die Body- und die Emitterzone 22, 24 p-dotiert. Die Herstellung einer n-dotierten Feldstoppzone 29 kann beispielsweise durch Protonenimplantation über die Rückseite 111 bzw. über die Rückseite 102 des noch nicht abgetragenen Wafers und einen sich daran anschließenden Temperaturprozess bei Temperaturen zwischen 350° C und 420° C und besonders bevorzugt im Temperaturbereich zwischen 360°C und 400°C erfolgen.

Auch die Grunddotierung der Driftzone 23 wird vorzugsweise in der erläuterten Weise durch eine Protonenimplantation in Kombination mit einem geeigneten Temperschritt erzeugt, wobei die Protonenimplantation vorzugsweise über die Vorderseite 201 erfolgt. Alternativ oder ergänzend kann diese Protonenimplantation aber auch über die Scheibenrückseite 111 erfolgen, und zwar besonders bevorzugt nachdem ein rückseitiger Dünnungsprozess durchgeführt wurde.

Figur 6 zeigt in Seitenansicht im Querschnitt eine auf Basis des behandelten Wafergrundmaterial realisierte vertikale Leistungsdiode. Mit dem Bezugszeichen 201 ist in Figur 6 die Vorderseite eines Halbleiterkörpers, in dem die Diode integriert ist, bezeichnet, während das Bezugszeichen 111 eine Rückseite dieses Halbleiterkörpers bezeichnet. Der Halbleiterkörper umfasst einen Waferabschnitt 100', der durch Zurückschleifen des anhand der Figuren 1 bis 3 erläuterten Wafers 100 erhalten wird. Auf diesen Waferabschnitt 100' ist optional die anhand von Figur 4 erläuterte Epitaxieschicht 200 aufgebracht.

Die Leistungsdiode weist im Bereich der Vorderseite 201 eine p-Emitterzone bzw. Anodenzone 31, eine sich an die p-Emitterzone anschließende Basiszone 32 sowie eine sich in vertikaler Richtung an die Basiszone 32 anschließende n-Emitterzone bzw. Kathodenzone 33 auf. Die Basiszone 32 ist entweder p- oder n-dotiert und dient bei in Sperrichtung betriebener Leistungsdiode zur Aufnahme der anliegenden Sperrspannung. Die Basiszone 32 ist in dem Beispiel durch einen Abschnitt der Epitaxieschicht 200 und durch einen Abschnitt der präzipitatarmen Halbleiterzone 103 des Waferabschnitts 100' gebildet. Der n-Emitter 33 kann ebenfalls vollständig in der präzipitatarmen Halbleiterzone 103 ausgebildet sein. Dieser n-Emitter wird beispielsweise durch Implantation von n-Dotierstoffatomen über die Rückseite 111 erzeugt. Der n-Emitter 33 kann jedoch auch abschnittsweise durch die Sauerstoffagglomerate aufweisende Halbleiterzone (Bezugszeichen 104 in den Figuren 1 bis 3) des Wafers gebildet sein. Maßgeblich ist jedoch, dass die die Sperrspannung aufnehmende Basiszone 32 nur durch präzipitatarme Halbleiterzonen 103 des Wafers gebildet wird.

Die Anodenzone 31 der Diode ist durch eine Anodenelektrode 34 kontaktiert, die einen Anodenanschluss A bildet. Die Kathodenzone 33 ist durch eine Kathodenelektrode 35 kontaktiert, die einen Kathodenanschluss K bildet.

Wenngleich der Schutzumfang durch die Ansprüche definiert ist, sind einige Aspekte der vorliegenden Beschreibung nachfolgend nochmals kurz zusammengefasst. Beschrieben ist:
1. ein Verfahren zur Behandlung eines Sauerstoff enthaltenden Halbleiterwafers (100), der eine erste Seite (101), eine der ersten Seite (101) gegenüberliegende zweite Seite (102), einen sich an die erste Seite (101) anschließenden ersten Halbleiterbereich (103'), und einen sich an die zweite Seite (102) anschließenden zweiten Halbleiterbereich (104') aufweist, mit folgenden Verfahrensschritten:
   - Bestrahlen der zweiten Seite (102) des Wafers (100) mit hochenergetischen Teilchen, wodurch Kristalldefekte in dem zweiten Halbleiterbereich (104') entstehen,
   - Durchführen eines ersten Temperaturprozesses, bei dem der Wafer (100) auf Temperaturen zwischen 700° C und 1100° C aufgeheizt wird;
2. ein Verfahren gemäß Punkt 1., bei dem die Temperatur während des Temperaturprozesses zwischen 780° C und 1020° C beträgt;
3. ein Verfahren gemäß einem der Punkte 1. oder 2., bei dem die Dauer des ersten Temperaturprozesses zwischen 1 Stunde und 20 Stunden beträgt;
4. ein Verfahren gemäß einem der Punkte 1. bis 3., bei dem der Wafer während des Temperaturprozesses zunächst für eine erste Zeitdauer, die kürzer ist als 10 Stunden, auf eine Temperatur zwischen 790° C und 810° C und anschließend für eine zweite Zeitdauer, die länger ist als 10 Stunden, auf eine Temperatur zwischen 985° C und 1015° C aufgeheizt wird.
5. ein Verfahren gemäß Punkt 4., bei dem die erste Zeitdauer 5 Stunden und die zweite Zeitdauer 20 Stunden beträgt;
6. ein Verfahren gemäß einem der zuvor genannten Punkte, bei dem die hochenergetischen Teilchen nicht-dotierende Teilchen sind;
7. ein Verfahren gemäß Punkt 6., bei dem die nichtdotierenden Teilchen Protonen, Edelgasionen oder Halbleiterionen sind;
8. ein Verfahren gemäß Punkt 7., bei dem die nichtdotierenden Teilchen Heliumionen, Neonïonen, Argonionen, Siliziumionen, Germaniumionen oder Kryptonionen sind;
9. ein Verfahren gemäß einem der zuvor genannten Punkte, bei dem eine Dicke des Wafers zwischen 400 µm und 1000 µm beträgt und bei dem die Bestrahlungsenergie zwischen 70 keV und 10 MeV beträgt;
10. ein Verfahren gemäß einem der Punkte 1. bis 8., bei dem die Dicke des Wafers zwischen 400 µm und 1000 µm beträgt und bei dem die Bestrahlungsenergie zwischen 2 MeV und 10 MeV beträgt;
11. ein Verfahren gemäß Punkt 7., bei dem die Implantationsdosis von Protonen zwischen 1·10¹³ cm⁻² und 1·10¹⁵ cm⁻² beträgt;
12. ein Verfahren gemäß einem der zuvor genannten Punkte, das folgenden Verfahrensschritt vor dem Bestrahlen der zweiten Seite (102) des Wafers (100) umfasst:
   - Durchführen eines zweiten Temperaturprozesses, bei dem der Wafer (100) auf eine Temperatur größer als 1000 °C aufgeheizt wird und bei dem wenigstens die erste Seite (100) einer feuchten und/oder oxidierenden Atmosphäre ausgesetzt wird;
13. ein Verfahren gemäß Punkt 12, bei dem die erste und zweite Seite einer feuchten und/oder oxidierenden Atmosphäre während des Temperaturprozesses ausgesetzt werden;
14. ein Verfahren gemäß einem der zuvor genannten Punkte, das nach dem Bestrahlen der zweiten Seite (102) des Wafers (100) und vor dem ersten Temperaturprozess folgenden Verfahrensschritt umfasst:
   - Durchführen eines weiteren Temperaturprozesses, bei dem der Wafer (100) auf Temperaturen zwischen 350 °C und 450° C aufgeheizt wird;
15. ein Verfahren gemäß Punkt 14., bei dem die Dauer des weiteren Temperaturprozesses zwischen 5 Stunden und 20 Stunden beträgt;
16. ein Verfahren gemäß einem der zuvor genannten Punkte, bei dem vor dem Bestrahlen des Wafers (100) Gräben (105) hergestellt werden, die sich ausgehend von der zweiten Seite (102) in den Wafer (100) hinein erstrecken;
17. ein Verfahren gemäß Punkt 16., bei dem die Gräben (105) vor Durchführung des ersten Temperaturprozesses mit einem Füllmaterial aufgefüllt werden;
18. ein Verfahren gemäß einem der zuvor genannten Punkte, das nach oder vor Durchführen des ersten Temperaturprozesses folgenden weiteren Verfahrensschritt aufweist:
   - Durchführen eines dritten Temperaturprozesses, bei dem wenigstens die erste Halbleiterzone (103) derart aufgeheizt wird, dass Sauerstoffatome aus dieser ersten Halbleiterzone (103) über die erste Seite (101) des Wafers ausdiffundieren;
19. ein Verfahren gemäß einem der Punkte 1. bis 17., das nach Durchführen des ersten Temperaturprozesses folgende Verfahrensschritte zur Herstellung einer n-dotierten Halbleiterzone (105) in der ersten Halbleiterzone umfasst:
   - Bestrahlen des Wafers (100) über wenigstens eine der ersten und zweiten Seite (101, 102) mit Protonen, wodurch Kristalldefekte in der ersten Halbleiterzone entstehen,
   - Durchführen eines weiteren Temperaturprozesses, bei dem der Wafer (100) wenigstens im Bereich der ersten Seite (101) auf Temperaturen zwischen 400° C und 570° C aufgeheizt wird, so dass wasserstoffinduzierte Donatoren entstehen;
20. ein Verfahren gemäß Punkt 19., bei dem die Dauer und die Temperatur des weiteren Temperaturprozesses so gewählt sind, dass die n-dotierte Halbleiterzone (105) in vertikaler Richtung des Halbleiterkörpers (100) wenigstens über 60% ihrer vertikalen Ausdehnung eine durch die Protonenbestrahlung erzeugte wenigstens annähernd homogene Dotierung aufweist;
21. ein Verfahren gemäß Punkt 20., bei dem die Dauer und die Temperatur des weiteren Temperaturprozesses so gewählt sind, dass die n-dotierte Halbleiterzone (105) in vertikaler Richtung des Halbleiterkörpers (100) wenigstens über 80% ihrer vertikalen Ausdehnung eine durch die Protonenbestrahlung erzeugte wenigstens annähernd homogene Dotierung aufweist;
22. ein Verfahren gemäß Punkt 18., das nach Durchführen des zweiten Temperaturprozesses folgende Verfahrensschritte zur Herstellung einer n-dotierten Halbleiterzone (105) in der ersten Halbleiterzone umfasst:
   - Bestrahlen des Wafers (100) über wenigstens eine der ersten und zweiten Seiten (101; 102) mit Protonen, wodurch Kristalldefekte in der ersten Halbleiterzone entstehen,
   - Durchführen eines weiteren Temperaturprozesses, bei dem der Wafer (100) wenigstens im Bereich der ersten Seite (101) auf Temperaturen zwischen 400° C und 570° C aufgeheizt wird, so dass wasserstoffinduzierte Donatoren entstehen;
23. ein Verfahren gemäß Punkt 22., bei dem die Dauer und die Temperatur des weiteren Temperaturprozesses so gewählt sind, dass die n-dotierte Halbleiterzone (105) in vertikaler Richtung des Halbleiterkörpers (100) wenigstens über 60% ihrer vertikalen Ausdehnung eine durch die Protonenbestrahlung erzeugte wenigstens annähernd homogene Dotierung aufweist;
24. ein Verfahren gemäß Punkt 23., bei dem die Dauer und die Temperatur des weiteren Temperaturprozesses so gewählt sind, dass die n-dotierte Halbleiterzone (105) in vertikaler Richtung des Halbleiterkörpers (100) wenigstens über 80% ihrer vertikalen Ausdehnung eine durch die Protonenbestrahlung erzeugte wenigstens annähernd homogene Dotierung aufweist;
25. ein Verfahren gemäß einem der Punkte 19. bis 24., bei dem die Temperatur des Temperaturprozesses zwischen 450° C und 550° C beträgt;
26. ein Verfahren gemäß einem der Punkte 19. bis 25., bei dem die Dauer des weiteren Temperaturprozesses zwischen 1 Stunde und 10 Stunden beträgt;
27. ein Verfahren gemäß einem der Punkte 19. bis 26., bei dem das Bestrahlen des Wafers (100) mit Protonen wenigstens zwei Bestrahlungsschritte umfasst, bei denen der Wafer mit Protonen unterschiedlicher Bestrahlungsenergie bestrahlt wird;
28. ein Verfahren gemäß einem der Punkte 19. bis 27., bei dem der Wafer (100) vor der Behandlung eine n-Grunddotierung aufweist;
29. ein Verfahren gemäß einem der Punkte 19. bis 28., bei dem der Halbleiterkörper über die erste und die zweite Seite (101, 102) mit Protonen bestrahlt wird;
30. ein Verfahren gemäß einem der zuvor genannten Punkte, das die Herstellung einer n-dotierten Feldstoppzone (29) in dem Wafer mit folgenden Verfahrensschritten umfasst:
   - Bestrahlen des Wafers (100) über wenigstens eine der ersten und zweiten Seiten (101, 102) mit Protonen, wodurch Kristalldefekte in der ersten Halbleiterzone entstehen,
   - Durchführen eines Temperaturprozesses, bei dem der Wafer (100) auf Temperaturen zwischen 350° C und 550° C aufgeheizt wird, so dass eine Feldstoppzone (29) mit wasserstoffinduzierten Donatoren entsteht;
31. ein Verfahren gemäß Punkt 30., bei dem die Protonenbestrahlung zur Herstellung der Feldstoppzone (29) über die zweite Seite (102) erfolgt und bei dem der Wafer (100) auf Temperaturen zwischen 350° C und 420° C aufgeheizt wird;
32. ein Verfahren gemäß Punkt 30. oder 31., bei dem die Dauer des Temperaturprozesses zur Herstellung der Feldstoppzone zwischen 30 Minuten und 2 Stunden beträgt;
33. ein Verfahren gemäß einem der Punkte 30. bis 32., bei dem mehrere Bestrahlungsschritte mit mehreren Bestrahlungsenergien für die Herstellung der Feldstoppzone angewendet werden;
34. ein Verfahren gemäß Punkt 33., bei dem während der mehreren Bestrahlungsschritte die Bestrahlungsdosis mit zunehmender Bestrahlungsenergie abnimmt;
35. ein Verfahren gemäß einem der zuvor genannten Punkte, bei dem auf die erste Seite (101) des Wafers (100) eine Isolationsschicht (302) und auf die Isolationsschicht (302) eine Halbleiterschicht (301) aufgebracht ist;
36. ein Verfahren gemäß einem der zuvor genannten Punkte, bei dem die Bestrahlung der zweiten Seite (102) des Wafers wenigstens zwei Bestrahlungsschritte mit unterschiedlichen Bestrahlungsenergien umfasst;
37. ein Verfahren gemäß Punkt 36., bei dem der Temperaturprozess wenigstens zwei zeitlich beabstandete Temperaturschritte umfasst, bei denen der Wafer (100) jeweils aufgeheizt wird, wobei wenigstens einer dieser Temperaturschritte zeitlich zwischen zwei Bestrahlungsschritten liegt;
38. ein Verfahren gemäß einem der zuvor genannten Punkte, bei dem zur Herstellung eines SOI-Substrats Sauerstoffatome nach Durchführung des ersten Temperaturprozesses in den ersten Halbleiterbereich (103') implantiert werden;
39. ein Verfahren zur Herstellung eines SOI-Substrats, das folgende Verfahrensschritte umfasst:
   - Bereitstellen eines ersten und eines zweiten Halbleiterwafers, die jeweils eine erste und eine zweite Seite aufweisen,
   - Durchführen des Verfahrens gemäß einem der Punkte 1. bis 37. für jeden der beiden Halbleiterwafer, um in jedem der beiden Wafer eine präzipitatarme Zone im Anschluss an dessen ersten Seite zu erzeugen,
   - Verbinden des ersten und zweiten Halbleiterwafers derart, dass deren erste Seiten einander zugewandt sind und dass eine Isolationsschicht zwischen den ersten Seiten der Halbleiterwafer vorhanden ist;
40. ein Verfahren gemäß Punkt 39., bei dem eine Oxidschicht auf der ersten Seite wenigstens eines der beiden Wafer hergestellt wird und bei dem die beiden Wafer mittels eines Waferbondverfahrens miteinander verbunden werden;
41. ein Verfahren zur Herstellung einer n-dotierten Zone in einem Halbleiterwafer, der eine erste Seite (101), eine der ersten Seite gegenüberliegende zweite Seite (102) und eine an die erste Seite (101) anschließende, an Sauerstoffpräzipitaten arme Zone (103) aufweist und das folgende Verfahrensschritte umfasst:
   - Bestrahlen des Wafers (100) über wenigstens eine der ersten und zweiten Seiten (101) mit Protonen, wodurch Kristalldefekte in der ersten Halbleiterzone entstehen,
   - Durchführen eines weiteren Temperaturprozesses, bei dem der Wafer (100) wenigstens im Bereich der ersten Seite (101) auf Temperaturen zwischen 400° C und 570° C aufgeheizt wird, so dass wasserstoffinduzierte Donatoren entstehen;
42. ein Verfahren gemäß Punkt 41., bei dem die Dauer und die Temperatur des weiteren Temperaturprozesses so gewählt sind, dass die n-dotierte Halbleiterzone (105) einen Bereich wenigstens annähernd homogener Dotierung aufweist, der sich in vertikaler Richtung des Halbleiterkörpers (100) wenigstens über 60% der vertikalen Ausdehnung der n-dotierten Halbleiterzone (105) erstreckt und der eine durch die Protonenbestrahlung erzeugte wenigstens annähernd homogene Dotierung aufweist;
43. ein Verfahren gemäß Punkt 42., bei dem die Dauer und die Temperatur des weiteren Temperaturprozesses so gewählt sind, dass die n-dotierte Halbleiterzone (105) einen Bereich wenigstens annähernd homogener Dotierung aufweist, der sich in vertikaler Richtung des Halbleiterkörpers (100) wenigstens über 80% der vertikalen Ausdehnung der n-dotierten Halbleiterzone (105) erstreckt und der eine durch die Protonenbestrahlung erzeugte wenigstens annähernd homogene Dotierung aufweist;
44. ein Verfahren gemäß Punkt 42. oder 43., bei dem ein Verhältnis zwischen maximaler Dotierungskonzentration und minimaler Dotierungskonzentration in dem Bereich homogener Dotierung maximal 3 beträgt;
45. ein Verfahren gemäß Punkt 44., bei dem ein Verhältnis zwischen maximaler Dotierungskonzentration und minimaler Dotierungskonzentration in dem Bereich homogener Dotierung maximal 2, maximal 1,5 oder maximal 1,2 beträgt;
46. ein Verfahren gemäß einem der Punkte 41. bis 45., bei dem die Temperatur des Temperaturprozesses zwischen 450° C und 550° C beträgt;
47. ein Verfahren gemäß einem der Punkte 41. bis 46., bei dem die Dauer des weiteren Temperaturprozesses zwischen 1 Stunde und 10 Stunden beträgt;
48. ein Verfahren gemäß einem der Punkte 41. bis 47., bei dem das Bestrahlen des Wafers (100) mit Protonen wenigstens zwei Bestrahlungsschritte umfasst, bei denen der Wafer mit Protonen unterschiedlicher Bestrahlungsenergie bestrahlt wird;
49. ein Verfahren gemäß einem der Punkte 41. bis 48., bei dem der Wafer (100) vor der Behandlung eine n-Grunddotierung aufweist;
50. ein Verfahren gemäß einem der Punkte 41. bis 48., bei dem der Halbleiterkörper über die erste und die zweite Seite (101, 102) mit Protonen bestrahlt wird;
51. ein Verfahren gemäß einem der Punkte 41. bis 45., bei dem der Wafer ein CZ-Wafer ist und das zur Herstellung der an Sauerstoffpräzipitaten armen Zone eine Temperaturbehandlung des Wafers bei Temperaturen zwischen 1000° C und 1180° C und einer Dauer zwischen 2 Stunden und 5 Stunden in einer oxidierenden oder feuchten Atmosphäre umfasst;
52. ein vertikales Leistungshalbleiterbauelement, das folgende Merkmale aufweist:
   - einen Halbleiterkörper der ein nach dem Czochralski-Verfahren hergestelltes Halbleitersubstrat aufweist, wobei das Halbleitersubstrat (100') eine an Sauerstoffpräzipitaten arme Halbleiterzone (103) aufweist,
   - eine Bauelementzone (23; 32), die dazu ausgebildet ist, bei sperrend angesteuertem Bauelement eine Sperrspannung aufzunehmen und die wenigstens abschnittsweise in der an Sauerstoffpräzipitaten armen Halbleiterzone (103) angeordnet ist;
53. ein Halbleiterbauelement gemäß Punkt 52., bei dem die die Sperrspannung aufnehmende Bauelementzone (23; 32) eine n-Grunddotierung aufweist, die durch wasserstoffinduzierte Donatoren gebildet ist;
54. ein Halbleiterbauelement gemäß Punkt 52. oder 53., bei dem der Halbleiterkörper eine auf das Halbleitersubstrat aufgebrachte Epitaxieschicht (200) aufweist und bei dem die die Sperrspannung aufnehmende Zone abschnittsweise in der Epitaxieschicht (200) angeordnet ist;
55. ein Halbleiterbauelement gemäß einem der Punkte 52. bis 54., das als MOSFET oder IGBT ausgebildet ist, der eine Driftzone (23) aufweist, welche die die Sperrspannung aufnehmende Zone bildet;
56. ein Halbleiterbauelement gemäß einem der Punkte 52. bis 54., das als Thyristor oder Diode ausgebildet ist, das eine n-Basis aufweist, welche die die Sperrspannung aufnehmende Zone bildet;
57. ein Verfahren zur Behandlung eines Sauerstoff enthaltenden, undotierten oder ausschließlich eine Grunddotierung aufweisenden Halbleiterwafers (100), der eine erste Seite (101), eine der ersten Seite (101) gegenüberliegende zweite Seite (102), einen sich an die erste Seite (101) anschließenden ersten Halbleiterbereich (103'), und einen sich an die zweite Seite (102) anschließenden zweiten Halbleiterbereich (104') aufweist, mit folgendem Verfahrensschritt:
   Bestrahlen der zweiten Seite des Wafers (100) mit hochenergetischen Teilchen, wodurch Kristalldefekte in dem zweiten Halbleiterbereich (104') entstehen;
58. ein Verfahren gemäß Punkt 57., das zusätzlich umfasst:
   Durchführen eines ersten Temperaturprozesses, bei dem der Wafer (100) auf Temperaturen zwischen 700° C und 1100° C aufgeheizt wird;
59. ein Verfahren gemäß Punkt 58., bei dem der Temperaturprozess während eines Implantations- oder Diffusionsprozesses, durch den Dotierstoffatome in den Wafer (100) eingebracht werden, oder während eines Oxidationsprozesses erfolgt;
60. ein Verfahren gemäß einem der Punkte 57. bis 59., bei dem die hochenergetischen Teilchen nicht-dotierende Teilchen sind;
61. ein Verfahren gemäß Punkt 60., bei dem die nichtdotierenden Teilchen Protonen, Edelgasionen oder Halbleiterionen sind;
62. ein Verfahren gemäß Punkt 61., bei dem die nichtdotierenden Teilchen Heliumionen, Neonionen, Argonionen, Siliziumionen, Germaniumionen oder Kryptonionen sind;
63. ein Verfahren gemäß einem der Punkte 57. bis 62., bei dem eine Dicke des Wafers zwischen 400 µm und 1000 µm beträgt und bei dem die Bestrahlungsenergie zwischen 70 keV und 10 MeV beträgt;
64. ein Verfahren gemäß einem der Punkte 57. bis 63., bei dem die Dicke des Wafers zwischen 400 µm und 1000 µm beträgt und bei dem die Bestrahlungsenergie zwischen 2 MeV und 10 MeV beträgt;
65. ein Verfahren gemäß Punkt 61., bei dem die Implantationsdosis von Protonen zwischen 1·10¹³ cm⁻² und 1·10¹⁵ cm⁻² beträgt;
66. ein Verfahren gemäß einem der Punkte 57. bis 65., das folgenden Verfahrensschritt vor dem Bestrahlen der zweiten Seite (102) des Wafers (100) umfasst:
   - Durchführen eines zweiten Temperaturprozesses, bei dem der Wafer (100) auf eine Temperatur größer als 1000 °C aufgeheizt wird und bei dem wenigstens die erste Seite (100) einer feuchten und/oder oxidierenden Atmosphäre ausgesetzt wird;
67. ein Verfahren gemäß Punkt 66., bei dem die erste und zweite Seite einer feuchten und/oder oxidierenden Atmosphäre während des Temperaturprozesses ausgesetzt werden;
68. ein Verfahren gemäß einem der Punkte 57. bis 67., das nach dem Bestrahlen der zweiten Seite (102) des Wafers (100) und vor dem ersten Temperaturprozess folgenden Verfahrensschritt umfasst:
   - Durchführen eines weiteren Temperaturprozesses, bei dem der Wafer (100) auf Temperaturen zwischen 350 °C und 450° C aufgeheizt wird;
69. ein Verfahren gemäß Punkt 68., bei dem die Dauer des weiteren Temperaturprozesses zwischen 5 Stunden und 20 Stunden beträgt;
70. ein Verfahren gemäß einem der Punkte 57. bis 69., bei dem vor dem Bestrahlen des Wafers (100) Gräben (105) hergestellt werden, die sich ausgehend von der zweiten Seite (102) in den Wafer (100) hinein erstrecken;
71. ein Verfahren gemäß Punkt 70., bei dem die Gräben (105) vor Durchführung des ersten Temperaturprozesses mit einem Füllmaterial aufgefüllt werden;
72. ein Verfahren gemäß einem der Punkte 57. bis 71., das nach oder vor Durchführen des ersten Temperaturprozesses folgenden weiteren Verfahrensschritt aufweist:
   - Durchführen eines dritten Temperaturprozesses, bei dem wenigstens die erste Halbleiterzone (103) derart aufgeheizt wird, dass Sauerstoffatome aus dieser ersten Halbleiterzone (103) über die erste Seite (101) des Wafers ausdiffundieren.

### Bezugszeichenliste

- 11: Sauerstoffatome
- 12: Leerstelle
- 21: Source-Zone
- 22: Body-Zone
- 23: Driftzone
- 24: Drain-Zone, Emitterzone
- 25: Source-Elektrode
- 26: Drain-Elektrode, Emitter-Elektrode
- 27: Gate-Elektrode
- 28: Gate-Dielektrikum
- 31: p-Emitter
- 32: Basis
- 33: n-Emitter
- 34, 35: Anschlusselektrode
- 100: Halbleiterwafer
- 100': Waferabschnitt nach Abtragen des Wafers
- 101: Vorderseite des Halbleiterwafers
- 102: Rückseite des Halbleiterwafers
- 103: präzipitatarme Halbleiterzone des Wafers
- 103': erster Halbleiterbereich des Wafers
- 104: Sauerstoffagglomerate enthaltende Halbleiterzone des Wafers
- 104': zweiter Halbleiterbereich des Wafers
- 104": Bereich des Halbleiterwafers mit erhöhter Leerstelenkonzentration
- 110: Gräben
- 111: Rückseite des abgetragenen Halbleiterwafers, Rückseite eines Halbleiterkörpers
- 200: Epitaxieschicht
- 201: Vorderseite der Epitaxieschicht, Vorderseite eines Halbleiterkörpers
- A: Anodenanschluss
- D: Drain-Anschluss
- E: Emitter-Anschluss
- G: Gate-Anschluss
- K: Kathodenanschluss
- S: Source-Anschluss

## Patentansprüche

1. Verfahren zur Behandlung eines Sauerstoff enthaltenden, undotierten oder ausschließlich eine Grunddotierung aufweisenden Halbleiterwafers (100), der eine erste Seite (101), eine der ersten Seite (101) gegenüberliegende zweite Seite (102), einen sich an die erste Seite (101) anschließenden ersten Halbleiterbereich (103'), und einen sich an die zweite Seite (102) anschließenden zweiten Halbleiterbereich (104') aufweist, mit folgendem Verfahrensschritt:
Bestrahlen der zweiten Seite des Wafers (100) mit Protonen oder Heliumionen so dass Gitterleerstellen in dem zweiten Halbleiterbereich (104') entstehen.

2. Verfahren nach Anspruch 1, das zusätzlich umfasst:
Durchführen eines ersten Temperaturprozesses, bei dem der Wafer (100) auf Temperaturen zwischen 700° C und 1100° C aufgeheizt wird.

3. Verfahren nach Anspruch 2, bei dem die Dauer des Temperaturprozesses so gewählt ist, dass sich Sauerstoffagglomerate in dem zweiten Halbleiterbereich (104') bilden und dass Gitterleerstellen aus dem ersten Halbleiterbereich (103') in den zweiten Halbleiterbereich (104') diffundieren.

4. Verfahren nach Anspruch 2 oder 3, bei dem die Dauer des ersten Temperaturprozesses zwischen 1 Stunde und 20 Stunden beträgt.

5. Verfahren nach einem der Ansprüche 2 oder 3, bei dem der Wafer während des Temperaturprozesses zunächst für eine erste Zeitdauer, die kürzer ist als 10 Stunden, auf eine Temperatur zwischen 790° C und 810° C und anschließend für eine zweite Zeitdauer, die länger ist als 10 Stunden, auf eine Temperatur zwischen 985° C und 1015° C aufgeheizt wird.

6. Verfahren nach einem der vorangehenden Ansprüche, bei dem eine Dicke des Wafers zwischen 400 µm und 1000 µm beträgt und bei dem die Bestrahlungsenergie zwischen 70 keV und 10 MeV beträgt.

7. Verfahren nach einem der Ansprüche 1 bis 6, bei dem die Implantationsdosis von Protonen zwischen 1·10¹³ cm⁻² und 1·10¹⁵ cm⁻² beträgt.

8. Verfahren nach einem der Ansprüche 2 bis 7, das folgenden Verfahrensschritt vor dem Bestrahlen der zweiten Seite (102) des Wafers (100) umfasst:
- Durchführen eines zweiten Temperaturprozesses, bei dem der Wafer (100) auf eine Temperatur größer als 1000 °C aufgeheizt wird und bei dem wenigstens die erste Seite (101) einer feuchten und/oder oxidierenden Atmosphäre ausgesetzt wird.

9. Verfahren nach Anspruch 8, bei dem die erste und zweite Seite einer feuchten und/oder oxidierenden Atmosphäre während des Temperaturprozesses ausgesetzt werden.

10. Verfahren nach einem der Ansprüche 2 bis 9, das nach oder vor Durchführen des ersten Temperaturprozesses folgenden weiteren Verfahrensschritt aufweist:
- Durchführen eines dritten Temperaturprozesses, bei dem wenigstens die erste Halbleiterzone (103) derart aufgeheizt wird, dass Sauerstoffatome aus dieser ersten Halbleiterzone (103) über die erste Seite (101) des Wafers ausdiffundieren.

11. Verfahren nach einem der vorangehenden Ansprüche, das die Herstellung einer n-dotierten Feldstoppzone (29) in dem Wafer mit folgenden Verfahrensschritten umfasst:
- Bestrahlen des Wafers (100) über wenigstens eine der ersten und zweiten Seiten (101, 102) mit Protonen, wodurch Kristall-defekte in der ersten Halbleiterzone entstehen,
- Durchführen eines Temperaturprozesses, bei dem der Wafer (100) auf Temperaturen zwischen 350° C und 550° C aufgeheizt wird, so dass eine Feldstoppzone (29) mit wasserstoffinduzierten Donatoren entsteht.

12. Verfahren nach einem der Ansprüche 3 bis 11, bei dem die Bestrahlung der zweiten Seite (102) des Wafers wenigstens zwei Bestrahlungsschritte mit unterschiedlichen Bestrahlungsenergien umfasst.

13. Verfahren nach Anspruch 12, bei dem der Temperaturprozess wenigstens zwei zeitlich beabstandete Temperaturschritte umfasst, bei denen der Wafer (100) jeweils aufgeheizt wird, wobei wenigstens einer dieser Temperaturschritte zeitlich zwischen zwei Bestrahlungsschritten liegt.

14. Verfahren zur Herstellung eines SOI-Substrats, das folgende Verfahrensschritte umfasst:
- Bereitstellen eines ersten und eines zweiten Halbleiterwafers, die jeweils eine erste und eine zweite Seite aufweisen,
- Durchführen des Verfahrens nach einem der Ansprüche 3 bis 13 für wenigstens einen der beiden Halbleiterwafer, um in diesem wenigstens einen der beiden Wafer eine präzipitatarme Zone im Anschluss an dessen ersten Seite zu erzeugen,
- Verbinden des ersten und zweiten Halbleiterwafers derart, dass deren erste Seiten einander zugewandt sind und dass eine Isolationsschicht zwischen den ersten Seiten der Halbleiterwafer vorhanden ist.

15. Verfahren nach einem der Ansprüche 3 bis 13, das zur Herstellung einer n-dotierten Zone in dem Halbleiterwafer folgende Verfahrensschritte umfasst:
- Implantieren von Protonen über die erste Seite (101) in den Wafer, wodurch Kristalldefekte in der ersten Halbleiterzone (103) entstehen und wodurch Protonen bis in einen von einer Implantationsenergie abhängigen End-Of-Range-Bereich innerhalb des Halbleiterwafers implantiert werden,
- Durchführen eines weiteren Temperaturprozesses, bei dem der Wafer (100) wenigstens im Bereich der ersten Seite (101) auf Temperaturen zwischen 400° C und 570° C aufgeheizt wird, so dass eine n-dotierte Halbleiterzone mit wasserstoffinduzierten Donatoren entsteht, und bei dem die Dauer und die Temperatur so gewählt sind, dass Protonen aus dem End-Of-Range-Bereich in Richtung der ersten Seite (101) diffundieren, so dass die n-dotierte Halbleiterzone (105) einen Bereich wenigstens annähernd homogener Dotierung aufweist, der sich in vertikaler Richtung des Halbleiterkörpers (100) wenigstens über 60% oder wenigstens über 80% eines Abstandes zwischen dem End-Of-Range-Bereich und der ersten Seite (101) erstreckt und der eine durch die Protonenimplantation erzeugte wenigstens annähernd homogene Dotierung aufweist, so dass ein Verhältnis zwischen maximaler Dotierungskonzentration und minimaler Dotierungskonzentration in dem Bereich homogener Dotierung maximal 3 beträgt.

## Claims

1. Method for treating an oxygen-containing semiconductor wafer (100) which is undoped or has exclusively a basic doping and has a first side (101), a second side (102) opposite the first side (101), a first semiconductor region (103') adjoining the first side (101), and a second semiconductor region (104') adjoining the second side (102), comprising the following method step:
irradiating the second side of the wafer (100) with protons or helium ions, thus giving rise to lattice vacancies in the second semiconductor region (104').

2. Method according to Claim 1, which additionally comprises:
carrying out a first thermal process, in which the wafer (100) is heated to temperatures of between 700°C and 1100°C.

3. Method according to Claim 2, in which the duration of the thermal process is chosen such that oxygen agglomerates form in the second semiconductor region (104') and that lattice vacancies diffuse from the first semiconductor region (103') into the second semiconductor region (104').

4. Method according to Claim 2 or 3, in which the duration of the first thermal process is between 1 hour and 20 hours.

5. Method according to any of Claims 2 or 3, in which the wafer, during the thermal process, is firstly heated to a temperature of between 790°C and 810°C for a first time duration, which is shorter than ten hours, and is subsequently heated to a temperature of between 985°C and 1015°C for a second time duration, which is longer than ten hours.

6. Method according to any of the preceding claims, in which a thickness of the wafer is between 400 µm and 100µm, and in which the irradiation energy is between 70 KeV and 10MeV.

7. Method according to any of Claims 1 to 6, in which the implantation dose of protons is between 1·10¹³ cm⁻² and 1·10¹⁵ cm⁻².

8. Method according to any of Claims 2 to 7, which comprises the following method step before irradiating the second side (102) of the wafer (100):
- carrying out a second thermal process, in which the wafer (100) is heated to a temperature of greater than 1000°C, and in which at least the first side (101) is exposed to a moist and/or oxidizing atmosphere.

9. Method according to Claim 8, in which the first and second sides are exposed to a moist and/or oxidizing atmosphere during the termal process.

10. Method according to any of Claims 2 to 9, which has the following further method step after or before carrying out the first thermal process.
- carrying out a third thermal process, in which at least the first semiconductor zone (103) is heated in such a way that oxygen atoms outdiffuse from said first semiconductor zone (103) via the first side (101) of the wafer.

11. Method according to any of the preceding claims, which comprises the production of an n-doped field stop zone (29) in the wafer by means of the following method steps:
- irradiating the wafer (100) with protons via at least one of the first and second sides (101, 102), thus giving rise to crystal defects in the first semiconductor zone,
- carrying out a thermal process in which the wafer (100) is heated to temperatures of between 350°C and 550°C, such that a field stop zone (29) with hydrogen-induced donors arises.

12. Method according to any of Claims 3 to 11, in which the irradiation of the second side (102) of the wafer comprises at least two irradiation steps with different irradiation energies.

13. Method according to Claim 12, in which the thermal process comprises at least two temporally separated thermal steps in which the wafer (100) is heated in each case, wherein at least one of said thermal steps lies temporally between two irradiation steps.

14. Method for producing an SOI substrate, which comprises the following method steps:
- providing a first and a second semiconductor wafer, each having a first and a second side,
- carrying out the method according to any of Claims 3 to 13 for at least one of the two semiconductor wafers in order to produce in said at least one of the two wafers a low-precipitate zone adjoining the first side thereof,
- connecting the first and second semiconductor wafers in such a way that their first sides face one another and that an insulation layer is present between the first sides of the semiconductor wafers:

15. Method according to any of Claims 3 to 13, which comprises the following method steps for producing n-doped zone in the semiconductor wafer:
- implanting protons into the wafer via the first side (101), whereby crystal defects arise in the first semiconductor zone (103) and whereby protons are implanted right into an end-of-range region - dependent on an implantation energy - within the semiconductor wafer,
- carrying out a further thermal process, in which the wafer (100) is heated to temperatures of between 400°C and 570°C at least in the region of the first side (101), such that an n-doped semiconductor zone with hydrogen-induced donors arises, and in which the duration and the temprerature are chosen such that protons diffuse from the end-of-range region in the direction of the first side (101), such that the n-doped semiconductor zone (105) has a region of at least over 60% or at least over 80% of a distance between the end-of-range region and the first side (101) and which has an at least approximately homogeneous doping produced by the proton implantation, such that a ratio between maximum doping concentration and minimum doping concentration in the region of homogeneous doping is a maximum of 3.

## Revendications

1. Procédé de traitement d'une plaquette (100) semi-conductrice contenant de l'oxygène non dopé ou ayant exclusivement un dopage de base, qui a une première face (101), une deuxième face (102) opposée à la première face (101), une première zone (103') semi-conductrice se raccordant à la première face (101) et une deuxième zone (104') semi-conductrice se raccordant à la deuxième face (102), ayant les stades de procédé suivant :
on expose la deuxième face de la plaquette (100) à des protons ou à des ions hélium de manière à créer des lacunes réticulaires dans la deuxième zone (104') semi-conductrice.

2. Procédé suivant la revendication 1, dans lequel, en outre :
on effectue un premier processus de mise en température, dans lequel on porte la plaquette (100) à des températures comprises entre 700°C et 1 100°C.

3. Procédé suivant la revendication 2, dans lequel on choisit la durée du processus de mise en température de façon à ce que des agglomérats d'oxygène se forment dans la deuxième zone (104') semi-conductrice et que des lacunes réticulaires diffusent de la première zone (103') semi-conductrice dans la deuxième zone (104') semi-conductrice.

4. Procédé suivant la revendication 2 ou 3, dans lequel la durée du premier processus de mise en température est comprise entre 1 heure et 20 heures.

5. Procédé suivant l'une des revendications 2 or 3, dans lequel on porte la plaquette pendant le processus de mise en température d'abord, pendant une première durée qui est plus courte que 10 heures, à une température comprise entre 790° C et 810° C et ensuite, pendant une deuxième durée qui est plus longue que 10 heures, à une température comprise entre 985° C et 1 015° C.

6. Procédé suivant l'une des revendications précédentes, dans lequel une épaisseur de la plaquette est comprise entre 400 µm et 1 000 µm et dans lequel l'énergie d'exposition est comprise entre 70 keV et 10 meV.

7. Procédé suivant l'une des revendications 1 à 6, dans lequel la dose d'implantation de protons est comprise entre 1·10¹³ cm⁻² et 1 ·10¹⁵ cm⁻².

8. Procédé suivant l'une des revendications 2 à 7, qui comprend le stade suivant de procédé avant l'exposition de la deuxième face (102) de la plaquette (100) :
- on effectue un deuxième processus de mise en température, dans lequel on porte la plaquette (100) à une température supérieure à 1 000° C et dans lequel on soumet au moins la première face (101) à une atmosphère humide et/ou oxydante.

9. Procédé suivant la revendication 8, dans lequel on soumet la première et la deuxième faces à une atmosphère humide et/ou oxydante pendant le processus de mise en température.

10. Procédé suivant l'une des revendications 2 à 9, qui a,
- on effectue un troisième processus de mise en température, dans lequel on chauffe la première zone (103) semi-conductrice de manière à ce que des atomes d'oxygène diffusent de cette première zone (103) semi-conductrice par la première face (101) de la plaquette.

11. Procédésuivant l'une des revendications précédentes, qui comprend la production d'une zone (29) d'arrêt de champ à dopage n dans la plaquette en effectuant des stades de procédé suivants :
- on expose la plaquette (100) par au moins l'une des premières et des deuxièmes faces (101, 102) à des protons en créant ainsi des défauts cristallins dans la première zonz semi-conductrice,
- on effectue un processus de mise en température, dans lequel on porte la plaquette (100) de température comprise entre 350°C et 550° C, de manière à créer une zone (29) d'arrêt de champ ayant des donneurs induits par de l'hydrogène.

12. Procédé suivant l'une des revendications 3 à 11, dans lequel l'exposition de la deuxième face (102) de la plaquette comprend au moins deux stades d'exposition à des énergies d'exposition différentes.

13. Procédé suivant la revendication 12, dans lequel le processus de mise en température comprend au moins deux stades de mise à température à distance dans le temps, dans lesquels la plaquette (100) est chauffée respectivement, au moins l'un de ces stades de mise en température se trouvant dans le temps entre deux stades d'exposition.

14. Procédé de production d'un substrat SOI, qui comprend les stades de procédé suivants :
- on se procure une première et une deuxième plaquettes semi-conductrices, qui ont respectivement une première et une deuxième faces,
- on effectue le procédé suivant l'une des revendications 3 à 13, pour au moins l'une des deux plaquettes semi-conductrices pour produire dans celle-ci sur sa première face, ensuite dans l'une au moins des deux plaquettes, une zone pauvre en précipité,
- on relie la première et la deuxième plaquettes semi-conductrices de façon à ce que leurs premières faces soient tournées l'une vers l'autre et de façon à ce qu'il y ait un couche isolante entre les premières faces des plaquettes semi-conductrices.

15. Procédé suivant l'une des revendications 3 à 13, qui comprend, pour la production d'une zone à dopage n dans la plaquette semi-conductrice les stades de procédés suivants :
- on implante des protons par la première face (101) dans la plaquette en créant ainsi des défauts cristallins dans la première zone (103) semi-conductrice et en implantant ainsi des protons au sein de la plaquette semi-conductrice jusque dans une zone End-Of-Range en fonction d'une énergie d'implantation,
- on effectue un autre processus de mise en température, dans lequel on porte la plaquette (100) au moins dans la zone de la première face (101) à des températures comprises entre 400° C et 570° C, de manière à créer une zone semi-conductrice à dopage n ayant des donneurs induits par de l'hydrogène et dans lequel on choisit la durée et la température de façon à ce que des protons diffusent de la zone End-Of-Range en direction de la première face (101), de sorte que la zone (105) semi-conductrice à dopage n a une région à dopage homogène au moins approximativement, qui s'étend dans la direction verticale du corps (100) semi-conducteur au moins sur 60% ou au moins sur 80% d'une distance entre la zone End-Of-Range et la première face (101) et qui a un dopage homogène au moins approximativement produit par l'implantation de protons, de manière à ce qu'un rapport entre une concentration maximale de dopage et une construction minimale de dopage et une construction minimale de dopage dans la région de dopage homogène soit au maximum de 3.
